(19) Europäisches Patentamt
European Patent Office
Office européen des brevets

(11) **EP 3 152 812 B1**

(12) **FASCICULE DE BREVET EUROPEEN**

(45) Date de publication et mention
de la délivrance du brevet:
**01.05.2019 Bulletin 2019/18**

(51) Int Cl.:
*H02J 7/00* (2006.01)    *H02J 3/00* (2006.01)
*G06Q 10/04* (2012.01)    *G06Q 10/06* (2012.01)

(21) Numéro de dépôt: **15726156.1**

(86) Numéro de dépôt international:
**PCT/EP2015/062277**

(22) Date de dépôt: **02.06.2015**

(87) Numéro de publication internationale:
**WO 2015/185561 (10.12.2015 Gazette 2015/49)**

(54) **PROCÉDÉ ET DISPOSITIF DE DÉTERMINATION DE TENSIONS ET/OU DE PUISSANCES DISPONIBLES DANS UN RÉSEAU ÉLECTRIQUE DE RECHARGE**

VERFAHREN UND VORRICHTUNG ZUR BESTIMMUNG VON IN EINEM ELEKTRISCHEN WIEDERAUFLADENETZWERK VERFÜGBAREN SPANNUNGEN UND/ODER LEISTUNGEN

METHOD AND DEVICE FOR DETERMINING VOLTAGES AND/OR POWERS AVAILABLE IN AN ELECTRICAL RECHARGING NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.06.2014 FR 1455042**

(43) Date de publication de la demande:
**12.04.2017 Bulletin 2017/15**

(73) Titulaire: **Institut Mines-Télécom**
**75013 Paris (FR)**

(72) Inventeurs:
• **ABI ABDALLAH, Fadi**
**22411 Mansourieh, Metn (LB)**
• **GAGNAIRE, Maurice**
**78400 Chatou (FR)**

(74) Mandataire: **Gevers & Orès**
**41 avenue de Friedland**
**75008 Paris (FR)**

(56) Documents cités:
• **RUIZ MARIO ALVARADO ET AL: "TeleWatt: An innovative electric vehicle charging infrastructure over public lighting systems", 2013 INTERNATIONAL CONFERENCE ON CONNECTED VEHICLES AND EXPO (ICCVE), IEEE, 2 décembre 2013 (2013-12-02), pages 741-746, XP032587574, DOI: 10.1109/ICCVE.2013.6799888**
• **ZDENEK KOLKA, MARTIN HORAK, VIERA BIOLKOVA: "Numerical algorithms for symbolic analysis of large circuits", WSEAS 5TH PROCEEDINGS, 16 décembre 2006 (2006-12-16), - 18 décembre 2006 (2006-12-18), pages 377-380, XP002735723,**
• **OEPOMO T S ED - RASTEGARNIA A ET AL: "A step-by-step method for Z-loop construction using graph theory and topology for power system studies", COMPUTATIONAL TECHNOLOGIES IN ELECTRICAL AND ELECTRONICS ENGINEERING, 2008. SIBIRCON 2008. IEEE REGION 8 INTERNATIONAL CONFERENCE ON, IEEE, PISCATAWAY, NJ, USA, 21 juillet 2008 (2008-07-21), pages 186-191, XP031308983, ISBN: 978-1-4244-2133-6**
• **TEDJA SANTANOE OEPOMO: "Graph theory and topology for 3 phase power system under faulted studies", IJRRAS, 28 février 2012 (2012-02-28), - 28 février 2012 (2012-02-28), pages 219-246, XP002735724, cité dans la demande**

## Description

### 1. Domaine de l'invention

Le domaine de l'invention est celui de la gestion d'un réseau électrique.

Plus précisément, l'invention concerne les réseaux électriques de recharge, par exemple des réseaux de recharge public, tel qu'un réseau de recharge basse tension pour véhicules électriques (VE), ou encore des réseaux électriques domestiques sur lesquels des dispositifs peuvent être connectés/déconnectés afin d'être rechargés.

La présente invention se rapporte plus particulièrement à la supervision en temps réel d'un réseau électrique de recharge.

### 2. Art antérieur

#### 2.1 Les réseaux électriques et leur modélisation

Actuellement, la très grande majorité de l'énergie électrique consommée dans le monde est acheminée par l'ensemble des réseaux électriques existants. En un peu plus d'un siècle, ce que représente le terme de « réseau électrique » est passé de la mutualisation de quelques unités de production à une interconnexion généralisée au niveau des continents tout entiers.

Si les étendues et les ramifications qui caractérisent ces réseaux en multiplient les performances et les potentiels, elles en font également des systèmes complexes, gérés par une multitude d'intervenants et tiraillés par des contraintes technico-économiques importantes.

Sur le plan purement technologique, ces contraintes sont principalement liées au fait que l'électricité ne se stocke pratiquement pas, et que par conséquent, l'intégralité des transferts d'énergies est gérée en « temps réel » de telle manière à conserver à la fois les valeurs normalisées des tensions et de la fréquence, ainsi que des marges de puissance permettant d'assurer la sûreté du système.

Pour leur gestion et leur supervision, différentes méthodes mathématiques et outils de modélisation sont classiquement utilisés afin d'analyser leur fonctionnement (matrices de réseau, calcul des courants de court-circuit, répartition de la puissance, régimes transitoires, stabilité, etc.).

Classiquement, un réseau électrique est modélisé sous la forme d'une pluralité de dispositifs interconnectés, chaque conducteur électrique présentant une impédance.

De manière bien connue, Robert Kirchhoff a proposé deux lois, à savoir la loi des noeuds et la loi des mailles, pour calculer les différences de potentiel aux bornes de chaque résistance et l'intensité du courant continu dans chaque branche d'un circuit complexe.

Une telle représentation sous la forme de noeuds et de branches a également été reprise dans le document « Graph Theory and Topology For 3 phase Power system under Faulted studies » (Tedja Santanoe Oepomo, IJRRAS 10(2) Février 2012) qui propose, pour améliorer l'analyse des réseaux électriques assistée par ordinateur, la construction d'une matrice impédance de boucle $Z_{loop}$ permettant la simulation sous forme de boucle de réseaux électriques présentant localement des courts-circuits ou des circuits ouverts.

#### 2.2 Les réseaux électriques de recharge et leur supervision

Plus récemment, le développement des véhicules électriques s'accompagne du déploiement respectif d'infrastructures de recharge. En France, de récentes études estiment notamment que deux millions de véhicules électriques (VE) seront en circulation en 2020.

Parallèlement, le développement des terminaux mobiles est accompagné du développement de réseaux électriques domestiques sur lesquels de tels terminaux mobiles peuvent être connectés/déconnectés afin d'être rechargés.

Le document " Telewatt: An innovative electric vehicle charging infrastructure over public lighting system", 2013 International conférence on connected vehicles and EXPO (ICCVE), divulgue l'exploitation des ressources d'un système d'éclairage public pour recharger des véhicules électriques. La puissance disponible au niveau de chaque borne de recharge est déterminée.

La gestion de tels réseaux de recharge devient cruciale et requiert, pour répondre aux besoins du consommateur, une supervision en temps réel permettant de déterminer la puissance disponible au niveau de chacune des bornes tout en prenant en compte la connexion/déconnexion des dispositifs ou, plus généralement, tout changement électrique dans le réseau.

En particulier, la disponibilité ou l'indisponibilité d'une borne est indiquée à l'usager par le biais d'une signalétique simple, par exemple, un voyant ou diode vert(e) ou un voyant ou diode rouge en fonction de la disponibilité ou de l'indisponibilité d'une borne.

Tenant compte de cette problématique, les inventeurs ont détecté que les techniques actuelles de gestion et de visualisation d'un réseau électrique ne sont pas adaptées à la supervision en temps réel d'un réseau électrique de recharge.

En effet, les méthodes actuelles sont basées en général sur une modélisation de la batterie à recharger par une impédance dont la valeur est calculée en fonction de la puissance tirée de la borne et de la tension théorique fournit par le générateur sans tenir compte des chutes de tension qu'ils peuvent y avoir lieu dans le réseau.

Pour ce faire, de telles méthodes de modélisation consistent à mettre en oeuvre plusieurs itérations des étapes successives de construction d'une matrice impédance de boucle du réseau électrique de recharge en fonction de l'impédance résistive de la batterie, d'inversion de cette matrice impédance de boucle, et de calcul des chutes de tension pour tout dipôle du réseau ainsi que les niveaux de courants traversant chacun de ces dipôles.

Ces méthodes de modélisation présentent donc une grande complexité notamment due à l'étape d'inversion de la matrice impédance de boucle.

En effet, les procédés d'inversion connus tels que les procédés d'inversion de Gauss-Newton, de Strassen, de Schonage, de Coppersmith-Winograd présentent respectivement pour une matrice de taille N une complexité de $N^3$ (pour Gauss-Newton), $N^{2,807}$, $N^{2,55}$, $N^{2,38}$ (dont certaines ne sont atteintes qu'asymptotiquement quand N tend vers l'infini).

Et pour un réseau de recharge cette complexité est multipliée par le nombre d'itérations à mettre en oeuvre afin d'avoir une bonne estimation du comportement du réseau électrique de recharge considéré.

Il apparaît donc clairement que les méthodes actuelles ne sont pas compatibles avec les besoins de visualisation en temps réel du consommateur qui cherche à un instant t à connaître les capacités de recharge, en d'autres termes la puissance disponible à chaque borne disponible, de l'infrastructure de recharge.

Il existe donc un besoin pour une nouvelle technique de gestion d'un réseau électrique permettant de délivrer une visualisation fiable en temps réel du comportement et des capacités de recharge disponibles dans ce réseau électrique de recharge.

## 3. Exposé de l'invention

L'invention propose une solution nouvelle qui ne présente pas l'ensemble de ces inconvénients de l'art antérieur, sous la forme d'un procédé de détermination de tensions et/ou de puissances disponibles dans un réseau électrique de recharge, le réseau électrique comprenant au moins un générateur de tension et au moins deux dipôles dont au moins une borne de recharge i correspondant, à un premier instant $t_1$, à une impédance de référence $z_{ii}$ prédéterminée.

Selon l'invention, le procédé de détermination met en oeuvre, à au moins un deuxième instant $t_2$, au moins une itération des étapes successives suivantes, pour au moins ladite borne de recharge i :

- estimation d'un changement de ladite impédance de référence $z_{ii}$ en une impédance modifiée $z'_{ii}$,
- actualisation d'une tension de ladite borne de recharge $i$, ladite actualisation mettant au moins en oeuvre une étape de détermination d'une matrice impédance de boucle inversée modifiée $Z_{loop\_M}^{-1}$ en fonction d'une matrice impédance de boucle inversée de référence $Z_{loop\_R}^{-1}$ et au moins en fonction d'une différence d'impédance entre ladite impédance modifiée $z'_{ii}$ et ladite impédance de référence $z_{ii}$, délivrant pour ladite borne de recharge $i$ une tension modifiée $U'_i$,
- vérification et/ou actualisation de la valeur d'une puissance, dite puissance disponible $P_{disp\_i}$, apte à être délivrée par ladite borne de recharge $i$ en fonction de ladite tension modifiée $U'_i$, d'une puissance maximale fournie par ledit générateur de tension, et/ou d'une tension de seuil dudit réseau électrique, délivrant en cas d'actualisation une puissance disponible actualisée.

En d'autres termes, selon l'invention, en cas de changement électrique dans le réseau électrique de recharge, l'étape d'actualisation de la valeur de la tension de la borne de recharge $i$ est mise en oeuvre simplement par détermination d'une matrice impédance de boucle inversée modifiée $Z_{loop\_M}^{-1}$ en fonction d'une matrice impédance de boucle inversée de référence $Z_{loop\_R}^{-1}$ et au moins d'une différence d'impédance entre l'impédance modifiée $z'_{ii}$ et l'impédance de référence $z_{ii}$.

Ainsi, l'invention propose une technique nouvelle permettant d'optimiser la description du comportement dynamique d'un réseau électrique en considérant que tout événement consistant à modifier un ou plusieurs paramètres de ce réseau électrique (typiquement le branchement ou le débranchement d'un dispositif sur une borne modifiant alors son impédance, la fluctuation de la valeur d'une impédance liée par exemple au vieillissement du dipôle auquel elle correspond, ou encore la variation de la valeur d'impédance en fonction du profile de recharge d'une batterie, un tel profil pouvant comprendre une pluralité de paliers ...) au regard d'une configuration de référence à un instant $t_1$, revient à déterminer l'état en tension et en puissance du réseau électrique à un instant $t_2$, tel que $t_2 = t_1 + \varepsilon$.

Par exemple, pour un profil de charge d'une batterie prédéterminée comprenant par exemple trois paliers, l'impédance de la borne de recharge occupée variera à chaque instant de transition entre ces paliers (un palier débutant par exemple à l'instant $t_1$ et terminant à l'instant $t_2$); la technique selon l'invention sera donc mise en oeuvre à chacune de ces transitions pour réévaluer la puissance disponibles apte à être délivrée par les autres bornes libres.

Ainsi, en fonction d'un profil de charge prédéterminé il est possible de synchroniser la mise en oeuvre de la technique selon l'invention avec les transitions entre chaque palier de chargement. En conséquence, au cours du chargement d'un même dispositif, le procédé selon l'invention est mis en oeuvre autant de fois qu'il y a de transitions dans le profil de chargement de la batterie du dispositif considéré, afin de déterminer en temps réel la puissance disponible apte à être délivrée par chaque autre borne de recharge libre.

De la même manière, la mise en oeuvre de la technique selon l'invention peut être mise en oeuvre en fonction du profil de distribution d'énergie du générateur de tension.

En effet, selon l'invention l'étape de détermination d'une matrice impédance inversée $Z_{loop\_M}^{-1}$ représentative du réseau électrique au deuxième instant $t_2$ est accélérée au regard de l'inversion de Gauss-Newton, de Strassen, de Schonage, ou encore de Coppersmith-Winograd selon l'art antérieur, car elle nécessite uniquement la connaissance de la matrice impédance de boucle inversée de référence $Z_{loop\_R}^{-1}$ de la configuration de référence à un instant $t_1$, et la détermination de la différence d'impédance, pour au moins une borne de recharge $i$, entre la configuration de référence de l'instant $t_1$, dans laquelle chaque borne de recharge $i$ du réseau électrique a une impédance prédéterminée et la configuration au deuxième instant $t_2$ correspondant au changement d'état (et donc de valeur d'impédance) d'au moins une borne de recharge du réseau électrique de recharge considéré.

Il est à noter que selon l'invention, lorsque plusieurs impédances sont modifiées au regard de la configuration de référence, l'actualisation d'une tension de la borne de recharge $i$, met en oeuvre une étape de détermination d'une matrice impédance de boucle inversée modifiée $Z_{loop\_M}^{-1}$ en fonction d'une matrice impédance de boucle inversée de référence $Z_{loop\_R}^{-1}$ et de chaque différence d'impédance détectée et/ou estimée.

Ainsi, si deux impédances respectivement de la borne i et de la borne j ont varié entre l'instant $t_1$ de référence et l'instant $t_2$, la détermination d'une matrice impédance de boucle inversée modifiée $Z_{loop\_M}^{-1}$ tiendra compte à la fois de la matrice impédance de boucle inversée de référence $Z_{loop\_R}^{-1}$ et des deux différences $(z'_{ii} - z_{ii})$ et $(z'_{jj} - z_{jj})$. De manière transposable, le changement d'état de $n$ impédances entraîne la prise en compte de $n$ différences en plus de la matrice impédance de boucle inversée de référence $Z_{loop\_R}^{-1}$.

En d'autres termes, au deuxième instant $t_2$, l'inversion matricielle classique de la matrice impédance de boucle du réseau électrique (où l'impédance de référence $z_{ii}$ a été remplacée par l'impédance modifié $z'_{ii}$) n'est pas mise en oeuvre pour déterminer la matrice impédance de boucle inversée modifiée $Z_{loop\_M}^{-1}$ représentative du réseau électrique à cet instant $t_2$.

Au contraire, la matrice impédance de boucle inversée modifiée $Z_{loop\_M}^{-1}$, permettant de déterminer les tensions et puissances disponibles aux bornes de chaque dipôle du réseau électrique de recharge, est obtenue grâce à une simple relation entre la matrice impédance de boucle inversée de référence $Z_{loop\_R}^{-1}$ de la configuration de référence à un instant $t_1$ et au moins la différence d'impédance ($z'_{ii}$ - $z_{ii}$).

Il est à noter que le procédé de détermination de tensions et/ou de puissances disponibles dans un réseau électrique de recharge selon l'invention est un procédé itératif. En effet, l'ensemble des trois étapes d'estimation, d'actualisation d'une tension de la borne de recharge $i$ et de vérification et/ou actualisation de la valeur de la puissance disponible est réitéré lorsque la valeur de la puissance disponible à tester est actualisée.

Ainsi, pour chaque itération nécessaire pour converger vers des valeurs fiables de tension et de puissance disponibles aux bornes des dipôles du réseau électrique de recharge, afin de satisfaire des contraintes du réseau électrique de recharge, à savoir la puissance maximale fournie par le générateur de tension, et/ou une tension de seuil dudit réseau électrique, la complexité induite est sensiblement réduite puisqu'il n'est plus nécessaire de réitérer une inversion de Gauss-Newton, de Strassen, de Schonage, de Coppersmith-Winograd.

Un tel gain en complexité à chaque itération rend possible une détermination en temps réel des caractéristiques de tension et de puissance disponibles pour le rechargement d'une batterie sur une borne de recharge du réseau électrique de recharge considéré.

Il est à noter qu'un dipôle selon l'invention correspond à un composant électrique possédant deux pôles (ou bornes), par exemple une ligne électrique, une ligne de perte, une borne de recharge, un dispositif électrique différent d'une borne de recharge par exemple un dispositif d'éclairage public, un distributeur de boisson lorsqu'on considère un réseau de recharge pour véhicules électriques (VE), pour batteries stationnaires, pour appareils électroménagers ou encore pour des dispositifs multimédia lorsqu'on considère des réseaux électriques domestiques sur lesquels des dispositifs peuvent être connectés/déconnectés afin d'être rechargés.

Ainsi, la détermination des tensions et/ou puissances disponibles au sein du réseau électrique de recharge n'est pas uniquement mise en oeuvre pour les seules bornes de recharge le constituant mais également pour les autres dispositifs qu'il comprend. Il est donc possible d'informer le consommateur de la puissance disponible apte à être délivrée par une borne de recharge tout en s'assurant conjointement que les autres dispositifs électriques du réseau électrique de recharge par exemple un dispositif d'éclairage fonctionneront correctement.

En d'autres termes, le procédé selon l'invention réutilise en permanence les au moins deux données d'entrée de référence, à savoir la matrice impédance de boucle inversée de référence $Z_{loop\_R}^{-1}$ et au moins l'impédance de référence $z_{ii}$, pour délivrer en tout point de l'infrastructure du réseau électrique de recharge les caractéristiques en tension et/ou en puissance disponible, et ce à chaque changement d'état électrique du réseau (ce traduisant par un changement d'au moins une impédance de référence $z_{ii}$ en une impédance modifiée $z'_{ii}$ d'au moins une borne de recharge du réseau électrique de recharge).

Selon un aspect particulier de l'invention, le procédé de détermination de tensions et/ou de puissances disponibles dans un réseau électrique de recharge comprend, audit premier instant $t_1$ les étapes d'initialisation suivantes :

- détermination d'une topologie dudit réseau électrique de recharge sous la forme d'un réseau d'impédances, chaque borne de recharge $i$ étant représentée par ladite impédance $z_{ii}$ prédéterminée,
- détermination d'une matrice impédance de boucle de référence $Z_{loop\_R}$ représentative dudit réseau électrique de recharge,
- pour au moins ladite borne de recharge i, détermination d'une puissance disponible à tester $P_{test\_i}$, et détermination d'une tension d'initialisation $U_i$ par inversion de ladite matrice impédance de boucle de référence $Z_{loop\_R}$ délivrant ladite matrice impédance de boucle inversée de référence $Z_{loop\_R}^{-1}$,
- mémorisation de ladite matrice impédance de boucle inversée de référence $Z_{loop\_R}^{-1}$.

En d'autres termes, le procédé selon l'invention est également apte à mettre en oeuvre, et ce de manière successive, une étape d'initialisation additionnelle pour déterminer lui même la matrice impédance de boucle inversée de référence $Z_{loop\_R}^{-1}$, suivie des étapes générales qui le constituent telles que décrites précédemment. Pour ce faire, le procédé selon l'invention utilise uniquement pour la détermination de la matrice impédance de boucle inversée de référence $Z_{loop\_R}^{-1}$ l'une des techniques classiques d'inversion comme par exemple l'inversion de Gauss-Newton, de Strassen, de Schonage ou de Coppersmith-Winograd.

Cette aptitude à mettre en oeuvre optionnellement une étape d'initialisation confère de l'autonomie au procédé selon l'invention qui en conséquence requiert uniquement la connaissance des impédances prédéterminées des dipôles constituant le réseau.

Il est à noter, que selon une autre alternative, le procédé selon l'invention peut également mettre en oeuvre une étape de réception de la matrice impédance de boucle inversée de référence $Z_{loop\_R}^{-1}$ déterminée ou mémorisée au préalable, et ce de manière indépendante, par des dispositifs existants de l'art antérieur.

Ainsi le procédé selon l'invention selon cette alternative est apte à être combiné avec des modules/techniques existant(e)s, ces techniques permettant une détermination ponctuelle d'un état de référence du réseau électrique de recharge, mais ne permettant pas une détermination dynamique de l'état du réseau en temps réel à chaque changement d'état du réseau de par leur trop grande complexité qui les rendent incompatibles avec une application temps réel.

Selon une autre caractéristique de l'invention, ladite puissance disponible à tester $P_{test\_i}$ apte à être délivrée par ladite borne de recharge i correspond, à la première itération, à la puissance maximale $P_{bMax}$ apte à être fournie par ladite borne de recharge $i$.

Ainsi, le procédé selon l'invention prend en compte les caractéristiques réelles de chaque borne de recharge. Il est à noter que si le réseau électrique comprend plusieurs bornes de recharge, il est possible de prendre en compte des valeurs de puissance maximale $P_{bMax}$ distinctes d'une borne de recharge à l'autre lorsque ces bornes de recharge sont différentes. Par exemple, il est possible qu'un réseau électrique de recharge comprenne plusieurs types de bornes de recharge dédiées respectivement à la recharge de voitures électriques, de scooter/moto électrique ou encore de vélo électrique, chaque type de borne de recharge étant de ce fait apte à fournir une puissance maximale propre au type de véhicule, qu'elle est destinée à recharger.

Selon un aspect particulier de l'invention, la matrice impédance de boucle de référence $Z_{loopR}$ correspond à un produit matriciel tel que :

$$Z_{loop\_R} = C^t * Z_{bb} * C$$

avec :

$C$ une matrice incidence dudit réseau électrique obtenue à partir de ladite topologie,
$Z_{bb}$ une matrice diagonale contenant une pluralité d'impédances, chaque impédance $z_{ii}$ correspondant à une borne de recharge i de ladite pluralité de dipôles.

La construction d'une telle matrice est décrite en détail dans le document « Graph Theory and Topology For 3 phase Power system under Faulted studies » (Tedja Santanoe Oepomo, IJRRAS 10(2) Février 2012).

Il est à noter que pour un réseau électrique dont la topologie reste fixe, la matrice d'incidence ne varie pas. Par exemple, le fait de brancher/débrancher une batterie d'une borne de recharge fait varier l'impédance $z_{ii}$ dans la matrice $Z_{bb}$ de la branche comportant la borne de recharge sans affecter la matrice d'incidence $C$ qui reste inchangée car la topologie du réseau reste la même.

Avantageusement, l'étape de détermination d'une matrice impédance de boucle inversée modifiée $Z_{loop\_M}^{-1}$ utilise une relation de type « Sherman-Morrison » telle que :

$$Z_{loop\_M}^{-1} = Z_{loop\_R}^{-1} - \frac{(z'_{ii} - z_{ii})Z_{loop\_R}^{-1} l_i^t l_i Z_{loop\_R}^{-1}}{1 + (z'_{ii} - z_{ii}) l_i Z_{loop\_R}^{-1} l_i^t}$$

avec $l_i$ un vecteur ligne formé par la $i^{ème}$ ligne de ladite matrice incidence C.

En effet, en partant de l'expression $Z_{loopR} = C^t * Z_{bb} * C$ et en posant $l_i$ comme étant le vecteur ligne formé par la $i^{ème}$ ligne de la matrice d'incidence $C$, $Z_{loop}$ peut s'écrire sous la forme suivante :

$$Z_{loop\_R} = [l_1^t, \dots, l_n^t] * \begin{bmatrix} z_{11} & \cdots & 0 \\ \vdots & \ddots & \vdots \\ 0 & \cdots & z_{nn} \end{bmatrix} * [l_1^t, \dots, l_n^t]^t ;$$

Ainsi,

$$Z_{loop\_R} = [l_1^t, \dots, l_n^t] * [z_{11} l_1^t, \dots, z_{nn} l_n^t]^t ;$$

soit,

$$Z_{loop\_R} = z_{11} l_1^t l_1 + \cdots + z_{nn} l_n^t l_n . \quad (1)$$

Lorsqu'un changement quelconque dans le réseau fait varier l'impédance $z_{ii}$ en $z'_{ii}$ $(1 \leq i \leq n)$ et par consé-

quent la matrice d'impédance de boucle de référence $Z_{loop\_R}$ en $Z_{loop\_M}$, la relation suivante est établie:

$$Z_{loop\_M} - Z_{loop\_R} = (z'_{ii} - z_{ii})\, l_i^t l_i . \quad (2)$$

D'où,

$$Z_{loop\_M} = Z_{loop\_R} + (z'_{ii} - z_{ii})\, l_i^t l_i . \quad (3)$$

Par ailleurs, on connaît la formule de Sherman-Morrison telle que si l'on considère une matrice A inversible de taille $N$, $u$ et $v$ deux vecteurs colonne de taille $N$. Si $(1 + v^t A^{-1} u) \neq 0$, alors :

$$(A + uv^t)^{-1} = A^{-1} - \frac{A^{-1}uv^t A^{-1}}{1 + v^t A^{-1} u}$$

dont la complexité, lorsqu'on a déjà calculé A$^{-1}$, est N$^2$.

En appliquant la formule de Sherman-Morrison d'inversion matricielle sur (3), l'inverse de $Z_{loop\_M}$ en fonction de $Z_{loop\_R}$ peut s'écrire de la manière suivante :

$$Z_{loop\_M}^{-1} = Z_{loop\_R}^{-1} - \frac{(z'_{ii} - z_{ii}) Z_{loop\_R}^{-1} l_i^t l_i Z_{loop\_R}^{-1}}{1 + (z'_{ii} - z_{ii}) l_i Z_{loop\_R}^{-1} l_i^t} \quad (4)$$

Ainsi, une fois l'inverse de la matrice impédance de boucle de référence $Z_{loop\_M}$ calculée une première fois (à l'aide d'un procédé d'inversion quelconque comme par exemple le procédé d'inversion de Gauss-Newton dont la complexité est de l'ordre de N$^3$, où N représente la taille de la matrice $Z_{loop\_R}$), l'inverse de $Z_{loop\_M}$ (qui n'est qu'une modification quelconque de la matrice impédance de boucle de référence $Z_{loop\_M}$ au niveau d'une de ces impédances $z_{ii}$) sera calculé à l'aide de la formule de Sherman-Morrison dont la complexité est de l'ordre de N$^2$.

Par ailleurs, à partir de ce principe général, il est à noter que lorsqu'un changement quelconque dans le réseau fait varier les impédances $z_{ii}$ et $z_{jj}$ respectivement en $z'_{ii}$ et $z'_{jj}$, ainsi, la matrice modifiée $Z_{loop\_M}$ peut s'écrire comme suit :

$$Z_{loop\_M} = Z_{loop\_R} + (z'_{ii} - z_{ii}) l_i^t l_i + \left(z'_{jj} - z_{jj}\right) l_j^t l_j \quad (5)$$

En posant

$$Z_{loop\_I} = Z_{loop\_R} + (z'_{ii} - z_{ii})\, l_i^t l_i \quad (6)$$

on obtient :

$$Z_{loop\_M} = Z_{loop\_I} + \left(z'_{jj} - z_{jj}\right) l_j^t l_j \quad (7)$$

Ainsi pour calculer l'inverse de $Z_{loop\_M}$, on applique d'abord la formule de Sherman-Morrison successivement sur (6) et (7) (en considérant que l'inverse de $Z_{loop\_R}^{-1}$ est déjà calculé à l'aide d'un procédé d'inversion quelconque, la complexité du calcul sera de l'ordre de N$^2$). Ce concept de calcul d'inversion matricielle à partir de $Z_{loop\_R}^{-1}$ se généralise facilement au cas où $Z_{loop\_R}$ subit une modification d'un nombre $p$ de ces impédances.

Selon un aspect particulier de l'invention, ladite étape d'estimation délivre ladite impédance modifiée $z'_{ii}$ telle

que $z'_{ii} = \frac{U_i{}^2}{P_{test\_i}}$.

En effet, il est à noter que par « *estimation d'un changement de ladite impédance de référence z_ii en une impédance modifiée z'_ii* », on entend le fait que le procédé selon l'invention détecte (détection de connexion d'une batterie) un changement d'impédance réel ou imminent, ou reçoit une information représentative d'un tel changement d'impédance réel ou imminent (requête de simulation de réservation d'une borne de recharge par un utilisateur via son terminal mobile). Pour autant, le procédé selon l'invention sait que l'impédance de référence $z_{ii}$ va être ou est modifiée, mais ne connaît pas la vraie valeur de l'impédance modifiée $z'_{ii}$ lors de la première itération des étapes du procédé selon l'invention.

Selon un autre aspect de l'invention, pour chaque itération, l'étape d'actualisation d'une tension de ladite borne de recharge i met en oeuvre au moins une itération des étapes successives suivantes:

- détermination de ladite matrice inversée modifiée $Z^{-1}_{loop\_M}$ en fonction de ladite matrice inversée de référence $Z^{-1}_{loop\_R}$ et de ladite différence d'impédance entre ladite impédance modifiée $z'_{ii}$ et ladite impédance de référence $z_{ii}$,

- détermination de ladite tension modifiée $U'_i$ à partir de ladite matrice inversée modifiée $Z^{-1}_{loop\_M}$,

- détermination d'une estimation d'une puissance $P'_i$ délivrée par la borne de recharge *i* telle que $P'_i = \frac{U'_i{}^2}{z'_{ii}}$,

- modifications de l'impédance de référence $z_{ii}$ de sorte à être égale à ladite impédance modifié $z'_{ii}$ délivrée par ladite étape d'estimation, et de la valeur de la matrice impédance de boucle inversée de référence $Z^{-1}_{loop\_R}$ de sorte à être égale à la valeur de la matrice impédance de boucle inversée modifiée $Z^{-1}_{loop\_M}$, et

- comparaison à un premier seuil prédéterminé de la valeur absolue de la différence entre ladite estimation de la puissance $P'_i$ et ladite puissance disponible à tester $P_{test\_i}$ de ladite borne de recharge *i*, et fin desdites itérations desdites étapes successives de ladite étape d'actualisation d'une tension de ladite borne de recharge *i* lorsque ladite valeur absolue est inférieure à ladite valeur seuil, sinon, pour l'itération suivante desdites étapes successives de ladite étape d'actualisation d'une tension de ladite borne de recharge *i*, modification de ladite impédance modifiée $z'_{ii}$ telle que $z'_{ii} = \frac{U'_i{}^2}{P_{test\_i}}$.

Ainsi, selon le procédé de l'invention, l'étape d'actualisation d'une tension de ladite borne de recharge i est elle même itérative afin de converger vers la vraie valeur de l'impédance modifiée $z'_{ii}$. Il est à noter qu'une fois la vraie valeur de l'impédance modifiée $z'_{ii}$ obtenue, les dernières valeurs de l'impédance de référence $z_{ii}$ et de la matrice impédance de boucle inversée de référence $Z^{-1}_{loop\_R}$ sont conservées tant que la vérification de la valeur de puissance disponible $P_{disp\_i}$ apte à être délivrée par la borne de recharge *i* n'a pas été effectuée, afin de servir de point de départ lorsque la puissance disponible à tester $P_{test\_i}$ est actualisée nécessitant la réitération des trois étapes d'estimation, d'actualisation d'une tension de ladite borne de recharge i et de vérification et/ou actualisation de la valeur de la puissance disponible. En outre, avantageusement, ces valeurs de l'impédance de référence $z_{ii}$ et de la matrice impédance de boucle inversée de référence $Z^{-1}_{loop\_R}$ actualisées sont par la suite utilisées pour un changement de configuration ultérieur à un instant $t_3 > t_2$.

Ainsi, on comprend que le procédé selon l'invention met en oeuvre selon ce mode de réalisation deux boucles itératives imbriquées.

Pour k itérations des étapes de l'étape d'actualisation, au regard d'une complexité globale égale à $kN^3$ d'un procédé classique mettant en oeuvre une inversion de Newton pour l'inversion matricielle, la complexité du procédé selon l'invention est réduite à $N^3 + (k-1) N^2$ où $N$ représente la taille de la matrice $Z_{loop\_R}$ représentative du réseau.

Par exemple, pour un réseau électrique comprenant à la fois des bornes de recharge et des lampes d'éclairage public, tel que la taille de la matrice $Z_{loop\_R}$ soit telle que $N \approx 90$, la complexité de détermination des puissance disponibles sur chaque dipôle est, lorsque k=5 itérations sont nécessaires, est de l'ordre de $5 \times 90^{+3} = 3.645.000$ avec l'inversion matricielle classique de Gauss-Newton, tandis qu'avec le procédé selon l'invention, cette complexité est seulement de $90^{+3} + 4. 90^{+2} = 761.400$, soit près de cinq fois moins.

Selon une aspect particulier, lorsqu'une puissance totale correspondant à la somme des estimations de puissance délivrée par lesdits au moins deux dipôles est supérieure à ladite puissance maximale fournie par ledit générateur de tension ou lorsqu'une tension modifiée $U'_i$ d'au moins un desdits au moins deux dipôles est inférieure à ladite tension de seuil dudit réseau électrique, ladite étape de vérification et/ou d'actualisation de la valeur d'une puissance disponible de ladite borne de recharge *i* met en oeuvre une étape d'actualisation de la valeur de ladite puissance disponible à tester $P_{test-i}$ pour l'itération suivante,

et l'étape d'actualisation de la valeur de ladite puissance disponible à tester $P_{test\_i}$ met en oeuvre une dichotomie telle que $P_{test\_i} = \frac{P_{max} + P_{min}}{2}$ avec $P_{max}$ correspondant, à l'initialisation, à la puissance maximale $P_{bMax}$ apte à être fournie par ladite borne de recharge *i,* puis à ladite estimation de la puissance $P'_i$ lorsque une puissance totale correspondant à la somme des estimations de puissance délivrée par lesdits au moins deux dipôles est supérieure à ladite puissance maximale fournie par ledit générateur de tension ou lorsqu'une tension modifiée $U'_i$ d'au moins un desdits au moins deux dipôles est inférieure à ladite tension de seuil dudit réseau électrique, et

$P_{min}$ correspondant, à l'initialisation, à une puissance nulle, puis à ladite estimation de la puissance $P'_i$ lorsque ladite puissance totale est inférieure à ladite puissance maximale fournie par ledit générateur de tension et lorsque chaque tension de chacun desdits au moins deux dipôles est supérieure à ladite tension de seuil dudit réseau électrique, et lorsque $P_{max}$ est inférieure à la puissance maximale $P_{bMax}$ apte à être fournie par ladite borne de recharge *i,* et la différence entre la puissance $P_{max}$ et la puissance $P_{min}$ est supérieure à un deuxième seuil prédéterminé.

La mise en oeuvre d'une dichotomie dont les paramètres évoluent tout en vérifiant les contraintes du réseau permet de converger simplement vers la puissance disponible en temps réel pour chaque borne de recharge.

Selon un aspect particulier, le procédé selon l'invention comprend en outre une étape de signalisation représentative de ladite puissance disponible, apte à être délivrée par ladite borne de recharge *i.*

Ainsi, il est par exemple possible de signaler au moyen d'un feu de signalisation lumineux clignotant ou encore au moyen d'une couleur de lumière prédéterminée délivrée par le feu lumineux, l'état de disponibilité/indisponibilité de chaque borne (par exemple vert/rouge respectivement) mais également, par le biais du clignotement ou d'une couleur prédéterminée telle que par exemple le bleu, la borne la moins énergivore.

Dans un autre mode de réalisation, l'invention concerne un dispositif de détermination de tensions et/ou de puissances disponibles dans un réseau électrique de recharge, ledit réseau électrique comprenant au moins un générateur de tension et au moins deux dipôles dont au moins une borne de recharge *i* correspondant, à un premier instant $t_1,$ à une impédance de référence $z_{ii}$ prédéterminée,

Selon l'invention, un tel dispositif comprend :

- un module d'estimation d'un changement de ladite impédance de référence $z_{ii}$ en une impédance modifiée $z'_{ii}$

- un module d'actualisation d'une tension de ladite borne de recharge *i*, ladite actualisation mettant au moins en oeuvre une étape de détermination d'une matrice impédance de boucle inversée modifiée $Z^{-1}_{loop\_M}$ en fonction d'une matrice impédance de boucle inversée de référence $Z^{-1}_{loop\_R}$ et au moins en fonction d'une différence d'impédance entre ladite impédance modifiée $z'_{ii}$ et ladite impédance de référence $z_{ii},$ délivrant pour ladite borne de recharge *i* une tension modifiée $U'_i,$

- un module de vérification et/ou d'actualisation de la valeur d'une puissance, dite puissance disponible $P_{disp\_i},$ apte à être délivrée par ladite borne de recharge *i* en fonction de ladite tension modifiée $U'_i,$ d'une puissance maximale fournie par ledit générateur de tension, et/ou d'une tension de seuil dudit réseau électrique, délivrant en cas d'actualisation une puissance disponible actualisée,

lesdits modules d'estimation, d'actualisation d'une tension, de vérification et/ou d'actualisation de la valeur d'une puissance, étant activés successivement, à au moins un deuxième instant $t_2,$ pour au moins ladite borne de recharge *i.*

Un tel dispositif de détermination de tensions et/ou de puissances disponibles dans un réseau électrique de recharge est notamment adapté à mettre en oeuvre le procédé de détermination de tensions et/ou de puissances disponibles dans un réseau électrique de recharge décrit précédemment. Ce dispositif de détermination de tensions et/ou de puissances disponibles dans un réseau électrique de recharge pourra bien sûr comporter les différentes caractéristiques relatives au procédé de détermination de tensions et/ou de puissances disponibles dans un réseau électrique de recharge décrit précédemment, qui peuvent être combinées ou prises isolément. Ainsi, les caractéristiques et avantages de ce dispositif de détermination de tensions et/ou de puissances disponibles dans un réseau électrique de recharge sont les mêmes que ceux du procédé de détermination de tensions et/ou de puissances disponibles dans un réseau électrique de recharge. Par conséquent, ils ne sont pas détaillés plus amplement.

L'invention concerne également un programme d'ordinateur comportant des instructions pour la mise en oeuvre d'un procédé de détermination de tensions et/ou de puissances disponibles dans un réseau électrique de recharge décrits précédemment lorsque ce programme est exécuté par un processeur.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

Le procédé selon l'invention peut donc être mis en oeuvre de diverses manières, notamment sous forme câblée et/ou sous forme logicielle.

L'invention concerne aussi un ou plusieurs supports d'informations lisibles par un ordinateur, et comportant des instructions d'un ou plusieurs programmes d'ordinateur tels que mentionnés ci-dessus.

## 4. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :

- les figures 1A et 1B présentent respectivement les principales étapes du procédé de détermination de tensions et/ou de puissances disponibles dans un réseau électrique de recharge selon un mode de réalisation de l'invention, et un mode de réalisation de l'étape de vérification et/ou actualisation de la valeur de la puissance disponible apte à être délivrée par une borne de recharge *i.*
- la figure 2 illustre un exemple de structure de réseau électrique de recharge,
- la figure 3 illustre une représentation sous forme d'impédances d'un réseau électrique de recharge,
- la figure 4 est une représentation schématique d'un dispositif de transmission radiofréquence selon un exemple de l'invention.

## 5. Description d'un mode de réalisation de l'invention

### 5.1 Principe général

L'invention propose de mettre en oeuvre efficacement et simplement une détermination en temps réel de l'état électrique de tout point de l'infrastructure d'un réseau, en utilisant à un instant $t_2$ une matrice impédance de boucle inversée modifiée $Z_{loop\_M}^{-1}$ obtenue simplement en fonction d'une matrice impédance de boucle inversée de référence $Z_{loop\_R}^{-1}$ déterminée classiquement à instant de référence $t_1$, et en fonction de toute(s) différence(s) d'impédance(s) détectée(s) entre la configuration de référence du réseau électrique à l'instant de référence $t_1$ et la configuration à l'instant $t_2$.

Une telle détermination est optimisée au regard de l'art antérieur puisqu'elle permet d'éviter l'inversion matricielle classique de la matrice impédance de boucle du réseau électrique et remplace cette étape par une détermination simplifiée nécessitant uniquement la connaissance de la matrice impédance de boucle inversée de référence $Z_{loop\_R}^{-1}$ de la configuration de référence à un instant $t_1$, et la détermination de la ou des différence(s) d'impédance(s) entre l'instant courant $t_2$ et l'instant de référence $t_1$.

En effet, si classiquement, le procédé d'inversion de Gauss-Newton est utilisée pour l'inversion matricielle, la complexité induite pour une matrice impédance de boucle de taille N est de l'ordre de $N^3$, alors que selon l'invention la complexité de l'étape permettant d'obtenir à un instant $t_2$ une matrice impédance de boucle inversée modifiée $Z_{loop\_M}^{-1}$ peut être réduite jusqu'à l'ordre de $N^2$.

Cette simplification permet d'atteindre un temps suffisamment faible pour être perçu comme quasi instantané par un opérateur cherchant à connaître en temps réel les valeurs de chute de tension ou encore de puissance consommée d'un réseau électrique alimentant, par exemple, des bornes de recharge de voitures électriques.

Ainsi, pour une configuration de réseau électrique soumise à des contraintes de chutes de tension et de puissances connues, l'invention permet de déterminer de façon quasi instantanée la disponibilité d'une borne de recharge.

Le procédé selon l'invention peut, par exemple, être combiné à tout procédé existant d'affectation de bornes de recharge à des véhicules tout-électriques ou hybrides, afin de déterminer la disponibilité ou l'indisponibilité d'une borne de recharge et peut à termes permettre d'orienter, par le biais d'une signalisation, les véhicules électriques vers les bornes de recharge les moins énergivores.

**5.2 Description d'un mode de réalisation particulier**

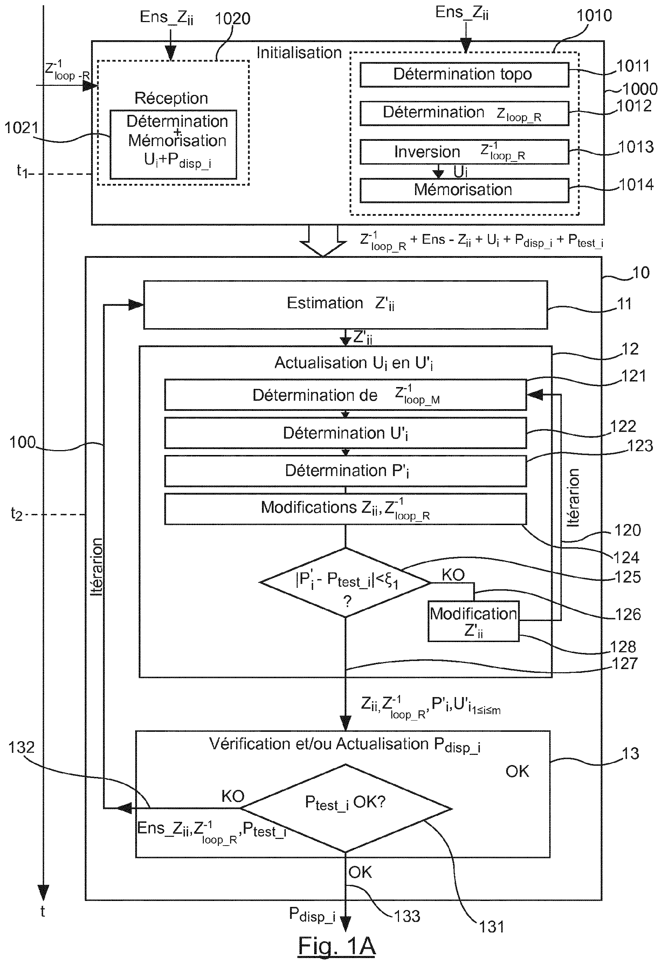

On présente en relation avec la figure 1A, les principales étapes mises en oeuvre par un procédé de détermination de tensions et/ou de puissances disponibles dans un réseau électrique de recharge. Ces différentes étapes sont par exemple mise en oeuvre au sein d'un dispositif de détermination de tensions et/ou de puissances disponibles dans un réseau électrique de recharge qui peut notamment être intégré au sein d'une unité de contrôle d'un réseau électrique de recharge.

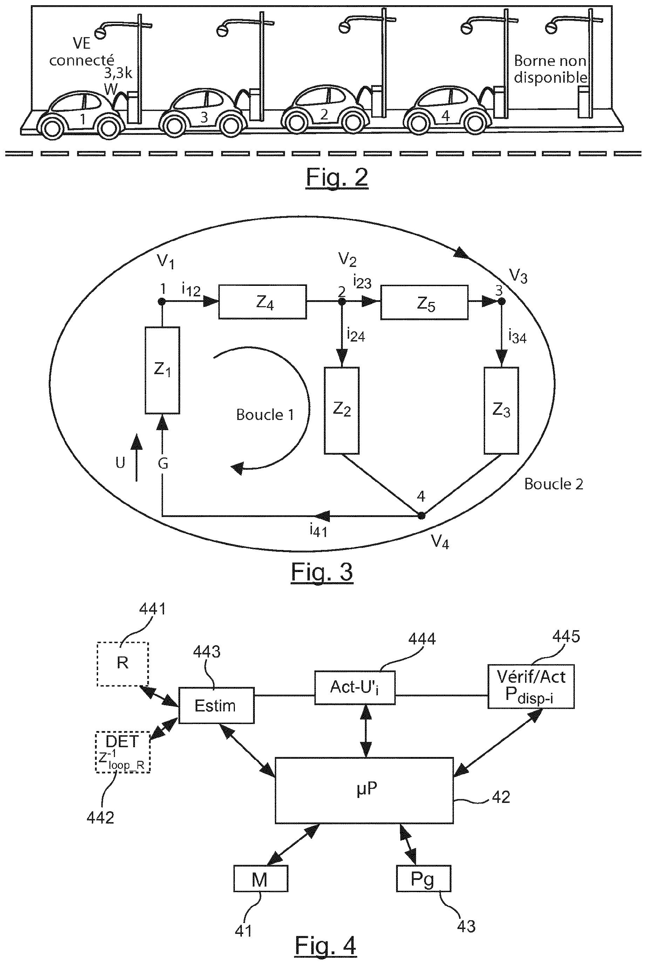

En particulier, le réseau électrique comprend au moins un générateur de tension et au moins deux dipôles dont au moins une borne de recharge i correspondant, à un premier instant $t_1$, à une impédance de référence $z_{ii}$ prédéterminée tel qu'illustré par exemple par la figure 3 décrite plus en détail ci-après.

Le procédé de détermination de tensions et/ou de puissances disponibles dans un réseau électrique de recharge selon l'invention comprend deux phases, une phase optionnelle d'initialisation 1000, et une phase de détermination dynamique 10 des caractéristiques de tensions et/ou puissance en tout point de la structure de recharge et à tout instant ou du moins à chaque changement de configuration au regard de la configuration d'initialisation à un instant $t_1$.

La phase optionnelle d'initialisation 1000 vise à obtenir l'ensemble des caractéristiques du réseau électrique de recharge dans la configuration d'initialisation, également appelée configuration de référence à l'instant $t_1$, comme si l'impédance de chaque dipôle électrique était constante au cours du temps. Dans ce cas, les impédances des bornes de recharges qui sont libres (c'est-à-dire non connectées) ont de grandes valeurs et correspondent à un circuit ouvert.

Une telle phase optionnelle d'initialisation 1000 peut être mise en oeuvre par un module ou un dispositif indépendant du dispositif de détermination de tensions et/ou de puissances disponibles dans un réseau électrique de recharge selon l'invention. Selon cette alternative, la phase d'initialisation consiste alors à recevoir 1020, les valeurs d'impédances $Ens\_Z_{ii}$ de l'ensemble des dipôles du réseau électrique et une matrice impédance de boucle inversée de référence $Z_{loop\_R}^{-1}$ déterminée ou mémorisée au préalable, et ce de manière indépendante, par des dispositifs existants de l'art antérieur.

Ainsi, le procédé selon l'invention, selon cette alternative, est apte à être combiné avec des modules/techniques existant(e)s de détermination ponctuelle d'un état de référence du réseau électrique de recharge. Toutefois, ces techniques de l'art antérieur ne permettent pas, à chaque changement de configuration, une détermination dynamique de l'état du réseau en temps réel, du fait de leur trop grande complexité qui les rendent incompatibles avec une application temps réel.

A partir de la matrice impédance de boucle inversée de référence $Z_{loop\_R}^{-1}$ et les impédances $Ens\_Z_{ii}$ reçues et en appliquant la méthode divulguée dans le document « Graph Theory and Topology For 3 phase Power system under Faulted studies » (Tedja Santanoe Oepomo, IJRRAS 10(2) Février 2012), il est ensuite possible de déterminer 1021 pour chaque dipôle du réseau électrique de recharge les tensions d'initialisation $U_i$ et la puissance disponible à tester $P_{test\_i}$ de ladite au moins une borne de recharge $i$ libre, c'est-à-dire non connectée, ou les puissances disponibles des bornes de recharge libres lorsque le réseau comprend plusieurs bornes libres.

Selon une autre alternative 1010, le dispositif de détermination de tensions et/ou de puissances disponibles dans un réseau électrique de recharge selon l'invention est apte à mettre en oeuvre lui même la phase d'initialisation 1000.

Dans ce cas, le dispositif de détermination de tensions et/ou de puissances disponibles dans un réseau électrique de recharge selon l'invention met tout d'abord en oeuvre une étape de détermination 1011 d'une topologie dudit réseau électrique de recharge sous la forme d'un réseau d'impédances, chaque borne de recharge $i$ étant représentée par ladite impédance $z_{ii}$ prédéterminée, tel qu'illustré par la figure 3 décrite plus en détail par la suite.

Puis, afin de déterminer les courants qui passent par toutes les impédances ainsi que la différence de potentiel aux bornes de chacune, la phase d'initialisation mise en oeuvre 1010 par le dispositif de détermination de tensions et/ou de puissances disponibles dans un réseau électrique de recharge selon l'invention comprend une étape de détermination 1012 d'une matrice impédance de boucle de référence $Z_{loop\_R}$ représentative du réseau électrique de recharge.

Une telle matrice impédance de boucle $Z_{loop\_R}$ est notamment obtenue en appliquant la technique de construction de matrice de boucle décrite dans le document « Graph Theory and Topology For 3 phase Power system under Faulted studies » (Tedja Santanoe Oepomo, IJRRAS 10(2) Février 2012) mettant en oeuvre la construction de cinq tables spécifiques à la boucle du circuit du réseau électrique considéré.

Selon cette construction particulière, la matrice impédance de boucle de référence $Z_{loop\_R}$ correspond à un produit matriciel tel que :

$$Z_{loop\_R} = C^t * Z_{bb} * C$$

avec :

> $C$ une matrice incidence dudit réseau électrique obtenue à partir de ladite topologie,
> $Z_{bb}$ une matrice diagonale contenant une pluralité d'impédances, chaque impédance $z_{ii}$ correspondant à une borne de recharge $i$ de ladite pluralité de dipôles.

Un exemple d'application de cette méthode sera notamment décrit par la suite pas à pas au regard de la figure 3.

Puis les courants de maille sont obtenus en appliquant la relation : $I = Z_{loop\_R}^{-1} U$. Ainsi, pour au moins la borne de recharge $i$ (considérée libre dans la configuration de référence de l'instant $t_1$), la tension d'initialisation $U_i$ de ladite borne de recharge $i$ est obtenue par inversion 1013 de la matrice impédance de boucle de référence $Z_{loop\_R}$ délivrant la matrice impédance de boucle inversée de référence $Z_{loop\_R}^{-1}$. Il s'agit par exemple d'une inversion de Gauss-Newton, de Strassen, de Schonage, de Coppersmith-Winograd.

Selon un aspect particulier du mode de réalisation représenté sur la figure 1A, la puissance disponible à tester $P_{test\_i}$ apte à être délivrée par la borne de recharge $i$ correspond, à la première itération de la phase de détermination dynamique 10, à la puissance maximale $P_{bMax}$ apte à être fournie par ladite borne de recharge $i$.

Enfin, afin d'être réutilisée par la suite pour un changement de configuration au regard de la configuration de référence de l'instant $t_1$, la matrice impédance de boucle inversée de référence $Z_{loop\_R}^{-1}$ est mémorisée 1014.

A un instant $t_2$, la phase de détermination dynamique 10 des caractéristiques de tensions et/ou puissance du réseau électrique reçoit en entrée une matrice impédance de boucle inversée de référence $Z_{loop\_R}^{-1}$ représentative d'une configuration du réseau électrique d'un instant précédent, ainsi que l'ensemble des valeurs d'impédances $Ens\_Z_{ii}$ de la configuration précédente et les tensions $U_i$ de chaque dipôle et les puissances disponibles à tester $P_{test\_i}$ de chaque dipôle correspondant à une borne de recharge de la configuration précédente.

Il est à noter que lors de la première mise en oeuvre de la phase de détermination dynamique 10, ces caractéristiques correspondent aux caractéristiques d'initialisation relatives à la configuration de référence de l'instant $t_1$ obtenues avec une inversion classique.

Toutefois, à un instant $t_3 > t_2$, ces caractéristiques peuvent provenir de la phase de détermination dynamique 10 des caractéristiques de tensions et/ou puissance du réseau électrique selon l'invention effectuée pour le changement de configuration précédent à un instant $t_2$ tel que $t_1 < t_2 < t_3$.

Au cours d'une première étape 11, le changement de ladite impédance de référence $z_{ii}$ en une impédance modifiée $z'_{ii}$ est estimé 11. En particulier, l'étape d'estimation délivre pour une borne $i$ une impédance modifiée $z'_{ii}$ telle que $z'_{ii} = \dfrac{U_i^2}{P_{test\_i}}$, avec $U_i$ et $P_{test\_i}$ les tension et puissance disponible à tester obtenues pour la borne de recharge $i$ à une configuration précédente relative à un instant $t_d$ tel que $t_1 < t_d < t_2$.

Il est à noter que le procédé de détermination de tensions et/ou de puissances disponibles dans un réseau électrique de recharge selon ce mode de réalisation de l'invention est un procédé itératif. En effet, lorsqu'un changement effectif ou imminent (l'utilisateur cherchant à recharger sa batterie a effectué une requête préalable à son approche pour connaître la disponibilité et la puissance disponible apte à être délivrée par chaque borne de recharge) d'impédance est estimé 11, le procédé selon l'invention « part » d'une valeur d'impédance modifiée d'initialisation pour converger à chaque itération vers la véritable valeur d'impédance modifiée.

Suite à cette estimation 11, le procédé selon l'invention met en oeuvre une étape d'actualisation 12 d'une tension de la borne de recharge $i$ qui est elle même itérative 120 afin de converger vers la vraie valeur de l'impédance modifiée $z'_{ii}$.

Puis, une fois la vraie valeur de l'impédance modifiée $z'_{ii}$ obtenue 12, la vérification 13 de la valeur de puissance disponible $P_{disp\_i}$ apte à être délivrée par la borne de recharge $i$ est effectuée, et lorsque la puissance disponible à tester $P_{test\_i}$ est modifiée les trois étapes d'estimation 11, d'actualisation 12 d'une tension de ladite borne de recharge $i$ et de vérification et/ou actualisation 13 de la valeur de la puissance disponible sont réitérées 100, dans le cas contraire, une puissance disponible actualisée $P_{disp\_i}$ est délivrée (celle-ci correspondant (1331) à la puissance maximale $P_{bMax}$ apte à être fournie par la borne de recharge $i$ (dans ce cas il a été vérifié que la puissance disponible d'initialisation correspondant à la puissance maximale $P_{bMax}$ apte à être fournie par la borne de recharge est cohérente avec les contraintes du réseau), ou correspondant (1333) à une puissance disponible actualisée à $P_{min}$).

Plus précisément, l'étape d'actualisation 12 met au moins en oeuvre une étape de détermination 121 d'une matrice impédance de boucle inversée modifiée $Z_{loop\_M}^{-1}$ en fonction d'une matrice impédance de boucle inversée de référence $Z_{loop\_R}^{-1}$ et au moins en fonction d'une différence d'impédance entre l'impédance modifiée $z'_{ii}$ et l'impédance de référence $z_{ii}$.

En particulier, l'étape de détermination 121 d'une matrice impédance de boucle inversée modifiée $Z_{loop\_M}^{-1}$ utilise une relation de type « Sherman-Morrison » telle que :

$$Z_{loop\_M}^{-1} = Z_{loop\_R}^{-1} - \frac{(z'_{ii} - z_{ii})Z_{loop\_R}^{-1}l_i^t l_i Z_{loop\_R}^{-1}}{1 + (z'_{ii} - z_{ii})l_i Z_{loop\_R}^{-1}l_i^t}$$

avec $l_i$ un vecteur ligne formé par la $i^{ème}$ ligne de ladite matrice incidence $C$.

Une fois, la matrice inversée modifiée $Z_{loop\_M}^{-1}$ obtenue rapidement avec la formule de Sherman-Morrison dont la complexité est de l'ordre de $N^2$ (contre $N^3$ pour le procédé d'inversion de Gauss-Newton), il est possible de déterminer 122 facilement la tension modifiée $U'_i$ aux bornes de chaque dipôle $i$ du réseau électrique de recharge. Un exemple numérique est détaillé par la suite en relation avec la figure 3 pour illustrer cette détermination de tension modifiée $U'_i$.

A partir de la tension modifiée $U'_i$ de la borne de recharge $i$, l'étape d'actualisation 12 met en oeuvre la détermination 123 d'une estimation d'une puissance $P'_i$ délivrée par la borne de recharge $i$ telle que $P'_i = \frac{U'^2_i}{z'_{ii}}$, puis les modifications (124) de l'impédance de référence $z_{ii}$ de sorte à être égale à ladite impédance modifiée $z'_{ii}$ délivrée par ladite étape d'estimation, et de la valeur de la matrice impédance de boucle inversée de référence $Z_{loop\_R}^{-1}$ de sorte à être égale à la valeur de la matrice impédance de boucle inversée modifiée $Z_{loop\_M}^{-1}$.

L'étape d'actualisation 12 met alors en oeuvre la comparaison 125 à un premier seuil prédéterminé de la valeur absolue de la différence entre ladite estimation de la puissance $P'_i$ et ladite puissance disponible à tester $P_{test\_i}$ de ladite borne de recharge $i$, et fin 127 (OK) desdites itérations desdites étapes successives (121, 122, 123, 124, 125) de ladite étape d'actualisation 12 d'une tension de ladite borne de recharge $i$ lorsque ladite valeur absolue $|P'_i - P_{test\_i}|$ est inférieure à ladite valeur seuil $\xi_1$ (par exemple $\xi_1$ égale 10W), sinon 126 (KO), pour l'itération suivante des étapes successives (121, 122, 123, 124, 125) de ladite étape d'actualisation d'une tension de ladite borne de recharge i, modification 128 de ladite impédance modifiée $z'_{ii}$ telle que $z'_{ii} = \frac{U'^2_i}{P_{test\_i}}$, et mémorisation de ces nouveaux paramètres de référence utilisés pour l'itération suivante des étapes (121, 122, 123, 124 et 125) constituant l'étape d'actualisation 12 selon l'invention.

Ainsi, les paramètres « modifiés » obtenus à une itération des étapes (121, 122, 123, 124 et 125) constituant l'étape d'actualisation 12, deviennent les paramètres de « référence » mémorisés pour l'itération suivante de ces étapes.

Il est à noter que lorsque la condition $|P'_i - P_{test\_i}| < \xi_1$ est satisfaite, la vraie valeur de l'impédance modifiée $z'_{ii}$ semble avoir été obtenue, en d'autres termes les étapes (121, 122, 123, 124 et 125) itératives de l'étape d'actualisation 12 ont convergé.

Toutefois, il est nécessaire de vérifier que les contraintes électriques du réseau sont satisfaites. Pour ce faire, la phase de détermination dynamique 10 met en oeuvre une étape de vérification et/ou actualisation 13 de la valeur d'une puissance, dite puissance disponible $P_{disp\_i}$, apte à être délivrée par la borne de recharge i en fonction de ladite tension modifiée $U'_i$, d'une puissance maximale $P_{gMax}$ fournie par le générateur de tension, et/ou d'une tension de seuil $U_{seuil}$ (par exemple $U_{seuil} = 210V$) du réseau électrique, délivrant en cas d'actualisation une puissance disponible modifiée $P_{disp\_i}$.

Une telle étape de vérification et/ou actualisation 13 de la valeur de la puissance disponible $P_{disp\_i}$, revient donc à tester 131 si la valeur de puissance disponible à tester $P_{test\_i}$ utilisée pour la première itération des trois étapes d'estimation 11, d'actualisation 12 d'une tension de ladite borne de recharge $i$ et de vérification et/ou actualisation 13 est fiable au regard des contraintes de fonctionnement du réseau électrique de recharge.

En effet, il est possible que le réseau électrique de recharge combine plusieurs fonctions telle qu'une fonction d'éclairage public et une fonction de recharge, la recharge et l'utilisation correspondante de la puissance disponible d'une borne ne doivent donc pas empêcher le bon fonctionnement d'un réseau d'éclairage.

Ainsi, par exemple, la nuit, la puissance disponible apte à être délivrée par une borne de recharge également utilisée pour fournir de l'éclairage public est inférieure à la puissance disponible apte à être délivrée par cette même borne de recharge en journée.

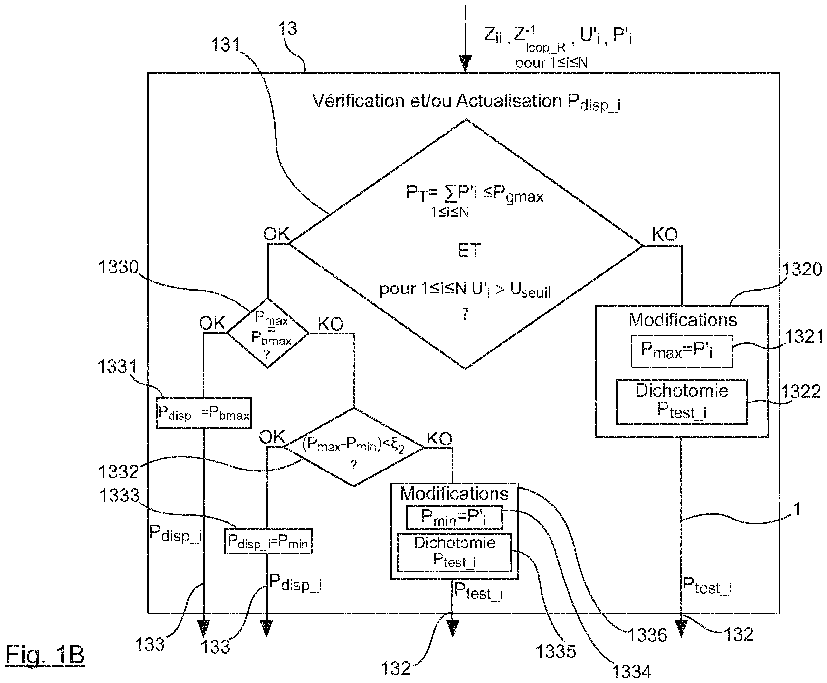

Un mode de réalisation de l'étape de vérification et/ou actualisation de la valeur de la puissance disponible apte à être délivrée par une borne de recharge i est illustré par la figure 1B.

Selon ce mode de réalisation, l'étape de vérification et/ou d'actualisation 13 de la valeur d'une puissance disponible $P_{disp\_i}$ de ladite borne de recharge *i* met en oeuvre une étape d'actualisation 1320 de la valeur de ladite puissance disponible à tester $P_{test\_i}$ lorsque le test 131 « $P_{test\_i}$ ok ? » revenant à vérifier « $P_T = \sum_{1 \leq i \leq n} P'_i \leq P_{gMax}$ ET pour $1 \leq i \leq n$ $U'_i > U_{seuil}$ » est négatif. En d'autres termes, lorsque le test 131 n'est pas satisfait (KO), c'est-à-dire lorsqu'une puissance totale $P_T$ correspondant à la somme des estimations de puissance $P'_i$ délivrée par les au moins deux dipôles est supérieure à la puissance maximale $P_{gMax}$ fournie par le générateur de tension ou lorsqu'une tension modifiée $U'_i$ d'au moins un des au moins deux dipôles est inférieure à la tension de seuil $U_{seuil}$ du réseau électrique, la puissance disponible à tester $P_{test\_i}$ (utilisée pour la première itération des trois étapes de la phase de détermination dynamique 10) est modifiée 1320.

La puissance disponible à tester $P_{test\_i}$ est également modifiée 1336 lorsque la puissance totale est inférieure à la puissance maximale fournie par le générateur de tension et lorsque chaque tension de chacun des au moins deux dipôles est supérieure à la tension de seuil du réseau électrique (en d'autres termes lorsque le test 131 est satisfait (OK)), et lorsque $P_{max}$ est inférieure à la puissance maximale $P_{bMax}$ apte à être fournie par la borne de recharge *i* (en d'autres termes lorsque le test 1330 n'est pas satisfait (KO)), et lorsque la différence entre la puissance $P_{max}$ et la puissance $P_{min}$ est supérieure à un deuxième seuil $\xi_2$ prédéterminé (par exemple $\xi_2$ égale 5W) (en d'autres termes lorsque le test 1332 n'est pas satisfait (KO)).

Tant que la puissance disponible à tester $P_{test\_i}$ est modifiée (132), la puissance disponible n'est pas déterminée (133).

Cette étape de modification de la valeur de la puissance disponible à tester $P_{test-i}$ met en oeuvre par exemple une dichotomie (1322, 1335) telle que $P_{test\_i} = \frac{P_{max}+P_{min}}{2}$ avec $P_{max}$ correspondant, à l'initialisation, à la puissance maximale $P_{bMax}$ apte à être fournie par la borne de recharge *i,* puis (1321) à l'estimation de la puissance $P'_i$ lorsqu'une puissance totale $P_T$ correspondant à la somme des estimations de puissance délivrée par l'ensemble des dipôles est supérieure à la puissance maximale fournie par le générateur de tension ou lorsqu'une tension modifiée $U'_i$ d'au moins une borne de recharge est inférieure à une certaine tension seuil $U_{seuil}$ du réseau électrique (en d'autres termes lorsque le test 131 n'est pas satisfait (KO)), et $P_{min}$ correspondant, à l'initialisation, à une puissance nulle, puis (1334) à l'estimation de la puissance $P'_i$ lorsque la puissance totale est inférieure à la puissance maximale fournie par le générateur de tension et lorsque chaque tension de chacun des au moins deux dipôles est supérieure à la tension de seuil du réseau électrique (en d'autres termes lorsque le test 131 est satisfait (OK)), et lorsque $P_{max}$ est inférieure à la puissance maximale $P_{bMax}$ apte à être fournie par la borne de recharge *i* (en d'autres termes lorsque le test 1330 n'est pas satisfait (KO)), et lorsque la différence entre la puissance $P_{max}$ et la puissance $P_{min}$ est supérieure à un deuxième seuil $\xi_2$ prédéterminé (par exemple $\xi_2$ égale 5W) (en d'autres termes lorsque le test 1332 n'est pas satisfait (KO)).

Puis, une fois la puissance disponible à tester $P_{test\_i}$ actualisée, elle est réutilisée pour l'itération suivante des trois étapes d'estimation 11 (l'impédance modifiée $z'_{ii}$ est recalculée telle que $z'_{ii} = \frac{U'i_i^2}{P_{test\_i}}$), d'actualisation 12 d'une tension de ladite borne de recharge *i* et de vérification et/ou actualisation 13 de la valeur de la puissance disponible.

Au contraire, lorsque le test 131 est satisfait (ok), on vérifie (1330) en outre si $P_{max} = P_{bMax}$ la puissance maximale apte à être fournie par la borne de recharge i, si c'est le cas (OK) la puissance disponible d'initialisation est vérifiée (1331) telle que $P_{disp\_i} = P_{bMax}$, sinon (KO) on vérifie (1332) si la différence entre $P_{max}$ et $P_{min}$ est inférieure au deuxième seuil $\xi_2$ prédéterminé (par exemple $\xi_2$ égale 5W), et si c'est le cas (OK) la puissance disponible est actualisée (1333) telle que $P_{disp\_i} = P_{min}$ ou dans le cas contraire, à savoir si $(P_{max} - P_{min}) > \xi_2$, $P_{min} = P'_i$ (1334).

**5.3 Exemple concret de la mise en oeuvre de l'invention.**

On considère par exemple un réseau électrique d'éclairage urbain illustré par la figure 2 et représenté par une armoire G (ou générateur) alimentant d'une part les lampes d'éclairages et d'autre part une borne de recharge pour véhicule électrique. L'armoire et les lampes sont soumises à deux contraintes électriques : d'une part la puissance totale consommée ne doit pas dépasser un certain niveau maximal autorisé par l'armoire *G*, et d'autre part, la chute de tension au niveau des lampes électriques ne doit pas atteindre une valeur minimale en dessous de laquelle la qualité d'éclairage des lampes serait altérée.

Ainsi, lors d'une consommation maximale de puissance par le réseau d'éclairage, une borne de recharge peut s'avérer être électriquement indisponible durant certaines périodes (le service d'éclairage étant considéré comme prioritaire vis-à-vis du service de recharge).

La disponibilité ou l'indisponibilité d'une borne est par exemple indiquée à l'usager par le biais d'une signalétique simple (diode verte ou diode rouge en fonction de la disponibilité ou de l'indisponibilité de la borne) respectivement.

Afin de déterminer la couleur de la diode associée à une borne à un instant donné, le procédé selon l'invention vise à prendre en compte l'arrivée d'un véhicule et le branchement de sa batterie sur la borne considérée. La batterie est modélisée par une impédance résistive que le procédé selon l'invention détermine en fonction de la puissance tirée de la borne. Une fois cette impédance résistive déterminée 12, le procédé selon l'invention devra vérifie 13 dans ces conditions si les contraintes du réseau sont respectées ou pas.

Le procédé selon l'invention est mis en oeuvre au niveau de chaque borne disponible, et après tout changement électrique subi par le réseau (comme par exemple le branchement/débranchement d'un véhicule électrique, l'allumage/extinction des lampes, variation dans le profil de recharge de la batterie du fait de son vieillissement etc.). La rapidité d'exécution du procédé selon l'invention est cruciale afin de limiter au maximum les marges électriques de sécurité et de profiter au mieux des puissances disponibles au niveau des bornes.

Un tel réseau électrique est illustré par la figure 3 formé d'un ensemble de dipôles, d'impédances $Z_1, ..., Z_5$ alimentés par un générateur (ou armoire d'alimentation) $G$ de tension $U = 220V$. On souhaite déterminer les courants qui passent par toutes les branches du réseau (c'est-à-dire $i_{12}, i_{23}, i_{24}$ et $i_{34}$), ainsi que le potentiel de tension à chaque noeuds 1,2 3 et 4 qu'on notera respectivement par $V_1, V_2, V_3$ et $V_4$ (on prendra $V_4$ comme potentiel de référence égale à zéro).

Selon un premier scénario, on considère que les impédances $Z_2$ et $Z_3$ représentent deux bornes de recharge qui pour l'instant sont libres (c'est-à-dire non connectées à des véhicules électriques). Ainsi, ces impédances auront de grandes valeurs modélisant un circuit ouvert au niveau des bornes. A noter que si un véhicule électrique se connecte à une des bornes, la valeur de l'impédance va changer d'une manière à refléter la puissance que le véhicule tire de la borne.

Selon la phase d'initialisation 1000, le procédé selon l'invention détermine lui même 1010 les caractéristiques d'initialisation de la configuration de référence à l'instant $t_1$.

Pour ce faire, partant de la topologie illustrée par la figure 3, une matrice impédance de boucle $Z_{loop\_R}$ est notamment obtenue en appliquant la technique de construction de matrice de boucle décrite dans le document « Graph Theory and Topology For 3 phase Power system under Faulted studies » (Tedja Santanoe Oepomo, IJRRAS 10(2) Février 2012) mettant en oeuvre la construction de cinq tables spécifiques à la boucle du circuit du réseau électrique considéré. Conformément à la technique de ce document appliquée à la topologie de la figure 3 on obtient les tables 1, 2, 3, 4 et 5 suivantes :

Table 1

| 1 | 2 |
|---|---|
| 1 | 4 |
| 2 | 3 |
| 2 | 4 |
| 3 | 4 |

Table 2

| 1 | 2 |
|---|---|
| 1 | 4 |
| 2 | 3 |

Table 3

| 2 | 4 |
|---|---|
| 3 | 4 |

Table 4

| |
|---|
| 1 |
| 2 |
| 4 |
| 3 |

Table 5

| Boucle 1 : | |
|---|---|
| 2 | 4 |
| 4 | 1 |
| 1 | 2 |
| Boucle 2 : | |
| 3 | 4 |
| 4 | 1 |
| 1 | 2 |
| 2 | 3 |

De ces tables, on déduit la matrice d'incidence $C$ du réseau électrique de recharge :

$$C = \begin{pmatrix} 1 & 1 \\ -1 & -1 \\ 0 & 1 \\ 1 & 0 \\ 0 & 1 \end{pmatrix}$$

Et par suite la matrice de boucle de référence $Z_{loop\_R}$ :

$$Z_{loop\_R} = \underline{C}^t Z_{bb} \underline{C} = \begin{pmatrix} Z_1 + Z_2 + Z_4 & Z_1 + Z_4 \\ Z_1 + Z_4 & Z_1 + Z_3 + Z_4 + Z_5 \end{pmatrix}$$

Où $Z_{bb}$ = $Diag(Z_4, Z_1, Z_5, Z_2, Z_3)$, où l'ordre des impédances correspond à leur ordre dans la table 1 (la première ligne dans la table 1 correspond à l'impédance qui se trouve entre les noeuds 1 et 2 sur la figure 3, la deuxième ligne correspond à celle qui se trouve entre les noeuds 1 et 4, etc.).

Si on prend : $Z_1 = Z_4 = Z_5 = 0.2\ \Omega$ et $Z_2 = Z_3 = 10^9 \Omega$ (bornes libres non connectées et correspondant à un circuit ouvert et de ce fait représentées par des impédances de grandes valeurs), on aura :

$$Z_{loop\_R} = \begin{pmatrix} 10^9 + 0.4 & 0.4 \\ 0.4 & 10^9 + 0.6 \end{pmatrix}$$

En utilisant un procédé classique d'inversion matricielle (comme par exemple l'inversion de Gauss-Newton), on aura :

$$Z_{loop\_R}^{-1} \approx \begin{pmatrix} 10^{-9} + 0.6 * 10^{-18} & -0.4 * 10^{-18} \\ -0.4 * 10^{-18} & 10^{-9} + 0.4 * 10^{-18} \end{pmatrix}$$

les courants des mailles de chaque boucle ($I_{m_1}$, et $I_{m_2}$) sont alors obtenus :

$$\begin{bmatrix} I_{m_1} \\ I_{m_2} \end{bmatrix} = Z_{loop\_R}^{-1} \begin{pmatrix} 220 \\ 220 \end{pmatrix} \approx \begin{bmatrix} 220(10^{-9} + 0.2 * 10^{-18}) \\ 220 * 10^{-9} \end{bmatrix}$$

Des courants de mailles ($I_{m_1}$ et $I_{m_2}$) et de la matrice d'incidence $C$ du réseau électrique de recharge, se déduisent les courants dans chaque branche du réseau :

$$\begin{pmatrix} i_{12} \\ i_{14} \\ i_{23} \\ i_{24} \\ i_{34} \end{pmatrix} = C \begin{pmatrix} I_{m_1} \\ I_{m_2} \end{pmatrix} \approx 220 \begin{pmatrix} 2 * 10^{-9} + 0.2 * 10^{-18} \\ -2 * 10^{-9} - 0.2 * 10^{-18} \\ 10^{-9} \\ 10^{-9} + 0.2 * 10^{-18} \\ 10^{-9} \end{pmatrix}$$

Ayant les courants dans chaque branche, on en déduit les potentiels de noeuds $V_1$, $V_2$ et $V_3$ de la manière suivante :

$$V_1 = U + Z_1 i_{14} = 220 - 220 * 0.2 * (2 * 10^{-9} + 0.2 * 10^{-18}) \approx 220V$$

$$V_2 = V_1 - Z_4 i_{12} \approx 220V$$

$$V_3 = V_2 - Z_5 i_{23} \approx 220V$$

Ainsi, en ayant les valeurs des impédances du circuit électrique et la tension $U$ du générateur, la première phase d'initialisation utilisant des techniques classiques a permis de déterminer les courants dans chaque branche et les tensions au niveau des noeuds du réseau considéré.

Par la suite, plusieurs exemples de scénario sont décrits. A partir de ces différents exemples, il est possible de déduire tous scénarios relatifs au cas où $x$ bornes de recharge sont mises en oeuvre parmi lesquelles $p$ bornes sont déjà occupées par des véhicules électriques ou tout autre type de dispositif mobile à recharger.

***5.3.1 Premier scénario : le réseau comprend deux bornes de recharge libres, et l'on souhaite occuper l'une d'elle.***

Selon ce premier scénario, on souhaite connaitre la puissance disponible au niveau de chacune des bornes tout en vérifiant les contraintes du réseau électrique de recharge considéré. Par exemple, selon ce premier scénario deux contraintes doivent être remplies :

1) Condition C1 : la puissance maximale $P_{gMax}$ que le générateur peut fournir est de 3100 W.
2) Condition C2 : la chute de tension ne doit pas descendre en dessous d'une valeur seuil égale à 214 V. En d'autres termes, il faut que les potentiels de noeudssoient tels que $V_1 > 214$, $V_2 > 214$ et $V_3 > 214$.

Par ailleurs, selon cet exemple, la puissance maximale $P_{bMax}$ qu'une borne peut fournir est de 3000 W (cette valeur est notamment donnée par le constructeur de bornes de recharge). Toutefois, en fonction de l'utilisation du réseau électrique (qui peut être utilisé à la fois pour de l'éclairage public ou pour une fonction de recharge), cette puissance maximale peut ne pas être totalement disponible.

C'est pourquoi l'objet de la présente invention est de trouver la puissance disponible au niveau de chaque borne de recharge $i$, notée $P_{disp\_i}$. Notons que $P_{disp-i}$ appartient à l'intervalle [0, $P_{bMax}$] dont la longueur est de $P_{bMax}$.

Pour résoudre ce problème, à la première itération on commence par tester (test 131 satisfait (OK)) si la puissance disponible à tester $P_{test-i} = P_{bMax}$ d'initialisation est vraiment disponible ou pas, si elle l'est (1331): $P_{disp\_i} = P_{test\_i} = P_{bMax}$, dans le cas contraire une méthode de dichotomie (1322, 1335) est utilisée pour réduire à chaque itération de moitié l'intervalle auquel appartient la puissance disponible $P_{disp\_i}$ que l'on cherche à déterminer.

Cette méthode consiste à tester à la première itération la valeur médiane de l'intervalle [0, $P_{bMax}$], c'est-à-dire la valeur $P_{test\_i} = P_{bmax}/2$ : si cette puissance est disponible, on aura $P_{disp\_i} \in \left[ \frac{P_{bMax}}{2}, P_{bMax} \right]$ et dans le cas contraire,

$$P_{disp\_i} \in \left[0, \frac{P_{bMax}}{2}\right].$$

Prenons le cas où $P_{disp\_i} \in \left[\frac{P_{bMax}}{2}, P_{bMax}\right]$. Ainsi, à la deuxième itération, on testera la valeur de puissance disponible $P_{test\_i} = \frac{3P_{bMax}}{4}$ : si cette puissance est disponible, $P_{disp\_i} \in \left[\frac{3P_{bMax}}{4}, P_{bMax}\right]$ et dans le cas contraire $P_{disp\_i} \in \left[\frac{P_{bMax}}{2}, \frac{3P_{bMax}}{4}\right]$.

Ainsi, à chaque itération de la méthode de dichotomie, la longueur de l'intervalle auquel appartient la puissance disponible $P_{disp\_i}$ que l'on cherche à déterminer est divisée par deux.

De la même manière, plusieurs itérations seront mises en oeuvre jusqu'à ce que la longueur de l'intervalle devienne inférieure à une certaine marge d'erreur ($\xi_1$ (par exemple $\xi_1$ égale 10W)) qu'on accepte pour la puissance disponible $P_{disp-i}$.

Par ailleurs, tester la disponibilité d'une puissance $P_{disp\_2}$ par exemple au niveau de la borne de recharge $Z_2$ ($i = 2$), revient à vérifier si les contraintes du réseau électrique C1 et C2 sont toujours satisfaites lorsque cette puissance disponible à tester $P_{test\_2}$ est tirée de la borne de recharge $Z_2$ ($i = 2$).

Pour ce faire, les courants dans les branches du réseau électrique de recharge et les potentiels de tension (ou chutes de tension) $V_1$, $V_2$ et $V_3$ doivent être calculés. Afin d'y parvenir, la valeur de l'impédance $Z_2$ qui dissipe une puissance disponible à tester $P_{test\_2}$ doit être déterminée, puis les étapes de détermination des courants et des chutes de tensions doivent être réitérées.

Or, déterminer la valeur de $Z_2$ consommant puissance disponible à tester $P_{test\_2}$ n'est pas trivial et requiert plusieurs étapes au cours desquelles $Z_2$ va converger vers sa « bonne » valeur.

En effet, $Z_2$ est calculée à partir de l'équation $Z_2 = V_2^2/P_{test\_i}$ et la chute de tension $V_2$ n'est pas connue à l'avance (la valeur de $V_2$ trouvée précédemment ($\approx 220V$) n'est vrai que dans le cas où $Z_2 = 10^9 \Omega$, et pas dans le cas où $Z_2$ dissipe une puissance disponible à tester $P_{test\_2}$).

Lors d'une première itération, le procédé selon l'invention débute avec une valeur initiale de $Z_2 = 220^2/P_{test\_2}$ et détermine les chutes de tensions $V_1$, $V_2$ et $V_3$.

A l'itération suivante 120, la valeur de $Z_2$ est ajustée 126 à partir de la nouvelle valeur obtenue à l'itération précédente (122) de $V_2$, et les potentiels de tensions $V_1$, $V_2$ et $V_3$ sont à nouveau déterminés (122), et ainsi de suite jusqu'à ce que la puissance consommée par $Z_2$ devienne assez proche de $P_{test\_2}$.

Ainsi à la première itération, la puissance disponible à tester $P_{test\_2} = P_{bMax} = 3000W$ est tout d'abord évaluée, la valeur d'impédance $Z'_2$ correspondante est donc : $Z'_2 = \frac{V_2^2}{P_{test\_2}} = \frac{220^2}{3000} = 16,133\ \Omega$ alors qu'à l'issue de la phase d'initialisation la valeur d'impédance de $Z_2$ était $Z_2 = 10^9 \Omega$.

Selon l'invention, on détermine alors $Z_{loop\_M}^{-1}(16,133)$ en fonction de $Z_{loop\_R}^{-1}(10^9)$ (à l'initialisation $Z_2 = Z_3 = 10^9 \Omega$). En utilisant (121) la formule de Sherman-Morrison, on obtient :

$$Z_{loop\_M}^{-1}(16,133) = Z_{loop\_R}^{-1}(10^9) - \frac{(16,133 - 10^9)Z_{loop\_R}^{-1}(10^9)\, l_2^t l_2\, Z_{loop\_R}^{-1}(10^9)}{1 + (16,133 - 10^9)\, l_2\, Z_{loop\_R}^{-1}(10^9)\, l_2^t}$$

Où $l_2$ représente le vecteur ligne dans la matrice d'incidence C correspondant à l'impédance $Z_2$. Dans notre cas, on a : $l_2 = (1, 0)$. En faisant le calcul, on obtient :

$$Z_{loop\_M}^{-1}(16,133) \approx \begin{pmatrix} 0.0604 & -0.02419 * 10^{-9} \\ -0.02419 * 10^{-9} & 10^{-9} \end{pmatrix}$$

Les courants de mailles correspondants sont:

$$\begin{bmatrix} I_{m_1} \\ I_{m_2} \end{bmatrix} = Z^{-1}_{loop\_M} \begin{pmatrix} 220 \\ 220 \end{pmatrix} \approx 220 \begin{bmatrix} 0.0604 - 0.02419 * 10^{-9}) \\ 0.97 * 10^{-9} \end{bmatrix}$$

Des courants de mailles ($I_{m_1}$ et $I_{m_2}$) et de la matrice d'incidence $C$ du réseau électrique de recharge, se déduisent les courants dans chaque branche du réseau :

$$\begin{pmatrix} i_{12} \\ i_{14} \\ i_{23} \\ i_{24} \\ i_{34} \end{pmatrix} = C \begin{pmatrix} I_{m_1} \\ I_{m_2} \end{pmatrix} \approx 220 \begin{pmatrix} 0.0604 \\ -0.0604 \\ 0.97 * 10^{-9} \\ 0.0604 \\ 0.97 * 10^{-9} \end{pmatrix}$$

Les chutes de tensions correspondantes sont:

$$V_1 = U + Z_1 i_{14} = 220 - 220 * 0.2 * 0.0604 \approx 217.34 \, V$$

$$V_2 = V_1 - Z_4 i_{12} \approx 214.684 \, V$$

$$V_3 = V_2 - Z_5 i_{23} \approx 214.684 \, V$$

D'après le calcul des tensions, il est à noter qu'en mettant une impédance $Z'_2 = 16{,}133 \, \Omega$, on obtient une chute de tension $V_2 \approx 214.684 \, V$ (et non plus $V_2 \approx 220 \, V$ comme on l'avait précédemment à l'initialisation (1000) lorsque $Z_2 = 10^9 \, \Omega$. Ainsi, la puissance consommée $P'_2$ par $Z'_2 = 16{,}133 \, \Omega$, est égale à :

$$P'_2 = \frac{V_2^2}{Z'_2} = \frac{214.684^2}{16{,}133} \approx 2856.8 \, W$$

Si on accepte une marge d'erreur de 10 W ($\xi_1$ =10W) sur la puissance que doit dissiper l'impédance $Z_2$ (c'est à dire (3000 $\pm$ 10) *W)*, le test 125 |3000 - $P'_2$| = 143.2 > 10 *W* n'est pas satisfait (KO). Il est donc nécessaire de réajuster à nouveau (126) la valeur de l'impédance $Z'_2$.

Ainsi, pour l'itération suivante, plusieurs modifications (126) successives sont mises en oeuvre : la valeur de l'impédance de référence $Z_2 = 10^9 \Omega$ issue de la phase d'initialisation est modifiée de sorte à être égale à la valeur d'impédance modifiée $Z'_2 = 16{,}133 \, \Omega$, la valeur de la matrice impédance de boucle inversée de référence $Z^{-1}_{loop\_R}(10^9)$ est modifiée de sorte à être égale à la valeur de la matrice impédance de boucle inversée modifiée $Z^{-1}_{loop\_M}(16{,}133)$, et la valeur d'impédance modifiée appelée $Z'_2$ qui dissipe la puissance disponible à tester $P_{test\_2} = 3000 \, W$ est déterminée 126 en fonction de $V_2$ qui vient d'être obtenue lors de la première itération : $Z'_2 = \frac{V_2^2}{P_{test\_2}} = \frac{214.684^2}{3000} = 15.363 \, \Omega.$

En d'autres termes, pour la deuxième itération des étapes (121, 122, 123, 124 et 125) constituant l'étape d'actualisation 12, $Z_2$ de la phase d'initialisation est remplacé par $Z'_2$ de la première itération de ces étapes, $Z^{-1}_{loop\_R}(10^9)$ est remplacée par $Z^{-1}_{loop\_M}(16{,}133)$ de la première itération ( $Z^{-1}_{loop\_M}$ de la première itération devient $Z^{-1}_{loop\_R}$ pour la deuxième itération).

Ainsi, les paramètres « modifiés » obtenu à une itération deviennent les paramètres de « référence » de l'itération suivante.

Ainsi, lors de la deuxième itération, $Z^{-1}_{loop\_M}(15.363)$ est déterminée (121) en fonction de $Z^{-1}_{loop\_R}(16{,}133)$ (à l'issue de l'itération précédente ($Z_2 = 16{,}133 \, \Omega$)) en utilisant la formule de Sherman-Morrison :

$$Z_{loop\_M}^{-1}(15.363) = \underline{Z}_{loop\_R}^{-1}(16,133) - \frac{(15.363 - 16,133)Z_{loop\_R}^{-1}(16,133)\, l_2^t l_2\, Z_{loop\_R}^{-1}(16,133)}{1 + (16,133 - 10^9)\, l_2 Z_{loop\_R}^{-1}(16,133)\, l_2^t}$$

On obtient alors:

$$Z_{loop\_M}^{-1}(15.363) \approx \begin{pmatrix} 0.0634 & -0.0253 * 10^{-9} \\ -0.0253 * 10^{-9} & 10^{-9} \end{pmatrix}.$$

Le courant des mailles correspondant est :

$$\begin{bmatrix} I_{m_1} \\ I_{m_2} \end{bmatrix} = Z_{loop\_M}^{-1} \begin{pmatrix} 220 \\ 220 \end{pmatrix} \approx 220 \begin{bmatrix} 0.0634 - 0.0253 * 10^{-9} ) \\ 0.97 * 10^{-9} \end{bmatrix}$$

ce qui permet de déduire les courants dans les branches :

$$\begin{pmatrix} i_{12} \\ i_{14} \\ i_{23} \\ i_{24} \\ i_{34} \end{pmatrix} = C \begin{pmatrix} I_{m_1} \\ I_{m_2} \end{pmatrix} \approx 220 \begin{pmatrix} 0.0634 \\ -0.0634 \\ 0.97 * 10^{-9} \\ 0.0634 \\ 0.97 * 10^{-9} \end{pmatrix}$$

Les chutes de tensions correspondantes sont (122) :

$$V_1 = U + Z_1 i_{14} = 220 - 220 * 0.2 * 0.0634 \approx 217.21\, V$$

$$V_2 = V_1 - Z_4 i_{12} \approx 214.42\, V$$

$$V_3 = V_2 - Z_5 i_{23} \approx 214.42\, V$$

Ainsi la puissance consommée $P'_2$ par $Z'_2$ est:

$$P'_2 = \frac{V_2^2}{Z'_2} = \frac{214.42^2}{15.363} \approx 2992.66\, W$$

Le test 125 délivre $|3000 - P'_2| = 7.34$, ce qui est inférieur à la marge d'erreur admise de 10 W ($\xi_1 = 10W$).

Donc, la valeur $Z'_2 = 15.363\Omega$ est une estimation acceptable de l'impédance $Z_2$ qui dissipe 3000 $W$ et consomme exactement 2992.66 $W$.

Ayant trouvé une bonne estimation de la valeur de l'impédance $Z_2$, il reste à vérifier 13 la disponibilité de la puissance 3000 W, en d'autres termes on vérifie si les contraintes C1 et C2 sont satisfaites quand la valeur de l'impédance $Z_2$ est $Z'_2 = 15.363\ \Omega$.

Du fait que $V_1 > 214$, $V_2 > 214$ et $V_3 > 214$, la contrainte C2 est satisfaite.
Pour vérifier la contrainte C1, il faut calculer la puissance totale dissipée par toutes les impédances et la comparer à la puissance maximale fournie par le générateur ; en effet,

$$P_T = Z_1 i_{14}^2 + Z_2 i_{24}^2 + Z_3 i_{34}^2 + Z_4 i_{12}^2 + Z_5 i_{23}^2$$

$$\approx 0.2 * (220 * 0.0634)^2 + 3000 + 10^9 * (220 * 0.97 * 10^{-9})^2 + 0.2$$

$$* (220 * 0.0634)^2 + 0.2 * (220 * 0.97 * 10^{-9})^2 \approx 3077.81 \, W < P_{gMax} = 3100 \, W$$

Ainsi, la contrainte C1 est aussi satisfaite. Donc la puissance disponible à tester $P_{test\_2}$ = 3000 *W est* disponible au niveau de l'impédance $Z_2$. Notons que si une des contraintes n'était pas satisfaite, la puissance disponible à tester $P_{test\_2}$ = 3000 *W* ne serait pas disponible.

Dans ce cas, d'autres valeurs de puissance $P_{test\_2}$ obtenues par dichotomie devraient être testées jusqu'à ce qu'on arrive à trouver la puissance maximale disponible, ou plus précisément, jusqu'à ce que la longueur de l'intervalle auquel appartient $P_{disp\_2}$ devienne inférieure à une certaine marge d'erreur acceptable et définie à l'avance.

Chaque changement de la valeur de puissance disponible à tester nécessite de re-déterminer, une bonne estimation de la valeur de l'impédance $Z_2$ comme décrit précédemment.

### 5.3.2 Deuxième scénario : le réseau comprend une borne de recharge libre et une borne de recharge occupée, et l'on souhaite occuper la borne de recharge libre

Selon ce scénario, on suppose que le premier scénario a eu lieu à un instant $t_2$ et qu'un véhicule électrique est branché sur la borne $Z_2$ qui lui délivre une puissance de 3000 W.

Par ailleurs, on suppose que la puissance maximale du générateur est de $P_{gMax}$ = 4500 W. Ainsi, la borne sera modélisée par l'impédance $Z_2$ = 15.363 $\Omega$ déterminée précédemment.

Dans ce cas, on cherche maintenant à savoir quelle serait la puissance disponible au niveau de la seule borne de recharge libre qu'il reste $Z_3$ si celle-ci devient occupée à un instant $t_3$.

On suppose que la puissance maximale (donnée par le constructeur de bornes) que peut fournir cette dernière borne de recharge $Z_3$ est de 2000 W.

Ainsi, $P_{disp\_3} \in [0,2000]$, où $P_{disp\_3}$ représente la puissance disponible au niveau de la borne libre de recharge $Z_3$.

Comme pour le premier scénario, à la première itération des étapes de la phase de détermination dynamique 10 mises en oeuvre pour la borne de recharge $Z_3$, la puissance disponible à tester $P_{test\_3}$ a la valeur maximale, c'est-à-dire 2000 W, en conséquence $Z'_3 = \frac{V_3^2}{P} = \frac{214.42^2}{2000} = 22.98 \, \Omega$ (alors qu'avant la borne de recharge $Z_3$ était libre et donc $Z_3 = 10^9 \Omega$) et on conserve la bonne estimation de la valeur de l'impédance $Z_2$ = 15.363 $\Omega$. Notons que la valeur de $V_3$ correspond à la valeur trouvée précédemment lorsque $Z_2$ = 15.363 $\Omega$ et $Z_3 = 10^9 \Omega$.

Comme pour le premier scénario, en utilisant (121) la formule de Sherman-Morrison, on obtient :

$$Z_{loop\_M}^{-1}(22,98) = Z_{loop\_R}^{-1}(10^9) - \frac{(22,98 - 10^9) Z_{loop\_R}^{-1}(10^9) \, l_3^t l_3 \, Z_{loop\_R}^{-1}(10^9)}{1 + (22,98 - 10^9) \, l_3 \, Z_{loop\_R}^{-1}(10^9) \, l_3^t}$$

Où $l_3$ = (0,1) représente le vecteur ligne dans la matrice d'incidence C correspondant à l'impédance $Z_3$ Et $Z_{loop\_R}^{-1}(10^9)$ l'inverse de la matrice impédance de boucle correspondant à $Z_2$ = 15.363 $\Omega$ et $Z_3 = 10^9 \Omega$.

De la même manière que pour le premier scénario, les courants de mailles correspondants ($I_{m_1}$ et $I_{m_2}$), les courants dans chaque branche ($i_{12}$, $i_{14}$, $i_{23}$, $i_{24}$, $i_{34}$) du réseau et les chutes de tensions correspondantes $V_1$, $V_2$ et $V_3$ sont obtenus.

En conséquence, $V_3$ mais également $V_2$ ont été modifiés. Il est donc nécessaire de re-déterminer de bonnes estimations des impédances $Z_2$ et $Z_3$.

Pour ce faire, le procédé selon l'invention, propose de mettre en oeuvre plusieurs itérations des étapes de l'étape d'actualisation 12 pour converger vers une bonne estimation $Z'_3$ de l'impédance $Z_3$ dissipant la puissance disponible à tester $P_{test\_3}$. En d'autres termes, pendant ces itérations nécessaires à la bonne estimation $Z'_3$ de l'impédance $Z_3$, la valeur de l'impédance $Z_2$ = 15.363 $\Omega$ est conservée.

Puis, une fois que cette valeur $Z'_3$ est obtenue, la bonne estimation $Z'_2$ de l'impédance $Z_2$ est relancée (révisée) au moyen d'itérations afin de re-converger comme expliqué précédemment et ainsi de suite...

Pour déterminer cette nouvelle valeur $Z'_2$, on conserve une valeur constante de l'impédance $Z_3 = Z'_3$, et la matrice $Z_{loop\_M}^{-1}$ et les autres paramètres obtenus à l'issue de l'obtention de la valeur $Z'_3$ sont utilisés comme paramètres de référence pour cette détermination de $Z'_2$.

Ainsi, la détermination de la bonne estimation de chaque impédance $Z_2$ et $Z_3$ est réitérée pour chaque impédance l'une après l'autre ($Z_2$ premier scénario, $Z'_3$ avec valeur fixe de $Z_2$, $Z'_2$ avec valeur fixe de $Z_3 = Z'_3$, $Z''_3$ avec valeur fixe de $Z_2 = Z'_2$, $Z''_2$ avec valeur fixe de $Z_3 = Z''_3$...) jusqu'à ce qu'on trouve les valeurs d'impédances qui permettront à $Z_2$ de dissiper $(3000 \pm 10)W$ et à $Z_3$ de dissiper la puissance disponible à tester $P_{tesu\_3}$ (c'est-à-dire tel que les deux tests $|P'_2 - P_{test\_2}| < \xi_1$ et $|P'_3 - P_{test\_3}| < \xi_1$ soient satisfaits). Une fois les bonnes estimations des impédances $Z_2$ et $Z_3$ trouvées, on passe à l'étape 13 de vérification et/ou d'actualisation de $P_{disp\_3}$ selon la méthode de dichotomie évoquée précédemment.

En d'autres termes, ce deuxième scénario ajoute une boucle d'itération sur les impédances $Z_2$ et $Z_3$ en plus de la boucle d'itération (100) des étapes (11, 12, 13) du procédé selon l'invention et de la boucle d'itération (120) mise en oeuvre au sein même de l'étape d'actualisation 12.

Il est à noter que dans le cas où le réseau électrique de recharge comprend plus de deux bornes de recharge, par exemple $x > 2$ parmi lesquelles $p < x$ sont occupées, la boucle itérative à ajouter lorsqu'on cherche à trouver la puissance disponible sur une des bornes libres revient à déterminer les $p$ impédances correspondantes aux $p$ bornes occupées ainsi que celle de la borne libre en question.

Ainsi, on comprend que le procédé selon l'invention met en oeuvre selon ce deuxième scénario trois boucles itératives imbriquées.

### 5.3.3 Troisième scénario : le réseau comprend deux bornes de recharge occupées, et l'une d'elle va être libérée.

Selon ce troisième scénario, on suppose que la borne de recharge d'impédance $Z_3$ va être libérée à un instant $t_4$. Pour déterminer, la puissance disponible $P_{disp\_3}$ au niveau de cette borne de recharge d'impédance $Z_3$ devenue libre, il est nécessaire de recalculer la valeur de l'impédance $Z_2$ dans cette nouvelle configuration (celle où la valeur de $Z_3$ devient égale à $10^9$).

Dans ce cas, la configuration à l'instant $t_3$ est utilisée comme configuration de référence, et les paramètres délivrés pour celle-ci sont utilisés comme paramètres de référence pour déterminer la nouvelle valeur de l'impédance $Z_2$ dans cette nouvelle configuration à cet instant $t_4$.

Une fois la bonne estimation $Z'_2$ obtenue, rechercher la puissance disponible $P_{disp\_3}$ au niveau de la borne de recharge d'impédance $Z_3$ nous ramène exactement à la même solution présentée dans le deuxième scénario.

### 5.4 Structure d'un dispositif

On présente finalement, en relation avec la figure 4, la structure simplifiée d'un dispositif de détermination de tensions et/ou de puissances disponibles dans un réseau électrique de recharge selon l'un des modes de réalisation décrits ci-dessus.

Le réseau électrique de recharge comprenant au moins un générateur de tension et au moins deux dipôles dont au moins une borne de recharge $i$ correspondant, à un premier instant $t_1$, à une impédance de référence $z_{ii}$ prédéterminée.

Mis en oeuvre au sein d'une unité de contrôle d'un réseau électrique de recharge, un tel dispositif comprend une mémoire 41 comprenant une mémoire tampon, une unité de traitement 42, équipée par exemple d'un microprocesseur $\mu P$, et pilotée par le programme d'ordinateur 43, mettant en oeuvre le procédé de détermination de tensions et/ou de puissances disponibles dans un réseau électrique de recharge selon un mode de réalisation de l'invention.

A l'initialisation, les instructions de code du programme d'ordinateur 43 sont par exemple chargées dans une mémoire RAM avant d'être exécutées par le processeur de l'unité de traitement 42. L'unité de traitement 42 reçoit par exemple, lorsque la topologie du réseau électrique est donnée en entrée les valeurs d'impédances **$Ens\_Z_{ii}$** de l'ensemble des dipôles du réseau électrique. Le microprocesseur de l'unité de traitement 42 met en oeuvre les étapes du procédé détermination de tensions et/ou de puissances disponibles dans un réseau électrique de recharge décrit précédemment, selon les instructions du programme d'ordinateur 43, pour déterminer en temps réel la puissance disponible apte à être délivrée par chaque borne de recharge.

Pour cela, le dispositif de détermination de tensions et/ou de puissances disponibles dans un réseau électrique de recharge comprend, outre la mémoire tampon 41, un module d'estimation 443 d'un changement de l'impédance de référence $z_{ii}$ en une impédance modifié $z'_{ii}$, un module d'actualisation 444 d'une tension de ladite borne de recharge $i$, l'actualisation mettant au moins en oeuvre une étape de détermination d'une matrice impédance de boucle inversée modifiée $Z_{loop\_M}^{-1}$ en fonction d'une matrice impédance de boucle inversée de référence $Z_{loop\_R}^{-1}$ et au moins en fonction d'une différence d'impédance entre l'impédance modifié $z'_{ii}$ et l'impédance de référence $z_{ii}$, délivrant pour la borne de recharge $i$ une tension modifiée $U'_i$, un module de vérification 445 et/ou d'actualisation de la valeur d'une puissance, dite puissance disponible $P_{disp\_i}$, apte à être délivrée par ladite borne de recharge $i$ en fonction de ladite tension modifiée $U'_i$, d'une puissance maximale fournie par ledit générateur de tension, et/ou d'une tension de seuil dudit réseau électrique, délivrant en cas d'actualisation une puissance disponible actualisée.

Les modules d'estimation, d'actualisation d'une tension, de vérification et/ou d'actualisation de la valeur d'une puissance, sont activés successivement, à au moins un deuxième instant $t_2$, pour au moins ladite borne de recharge i par le microprocesseur de l'unité de traitement 42.

Optionnellement, le dispositif de détermination de tensions et/ou de puissances disponibles dans un réseau électrique de recharge comprend un module de réception 441 dune la matrice impédance de boucle inversée de référence $Z^{-1}_{loop\_R}$ déterminée ou mémorisée au préalable ou un module de détermination 442 de cette matrice impédance de boucle inversée de référence $Z^{-1}_{loop\_R}$.

## Revendications

1. Procédé de détermination de tensions et/ou de puissances disponibles dans un réseau électrique de recharge, ledit réseau électrique comprenant au moins un générateur de tension et au moins deux dipôles dont au moins une borne de recharge $i$ correspondant, à un premier instant $t_1$, à une impédance de référence $z_{ii}$ prédéterminée, **caractérisé en ce que** ledit procédé de détermination met en oeuvre, à au moins un deuxième instant $t_2$, au moins une itération des étapes successives suivantes, pour au moins ladite borne de recharge $i$ :

   - estimation (11) d'un changement de ladite impédance de référence $z_{ii}$ en une impédance modifiée $z'_{ii}$,
   - actualisation (12) d'une tension de ladite borne de recharge $i$, ladite actualisation mettant au moins en oeuvre une étape de détermination d'une matrice impédance de boucle inversée modifiée $Z^{-1}_{loop\_M}$ en fonction d'une matrice impédance de boucle inversée de référence $Z^{-1}_{loop\_R}$ et au moins en fonction d'une différence d'impédance entre ladite impédance modifiée $z'_{ii}$ et ladite impédance de référence $z_{ii}$, délivrant pour ladite borne de recharge i une tension modifiée $U'_i$, ladite matrice impédance de boucle inversée de référence $Z^{-1}_{loop\_R}$ étant obtenue à partir d'une matrice impédance de boucle de référence $Z_{loop\_R}$ correspondant à un produit matriciel tel que :

$$Z_{loop\_R} = C^t * Z_{bb} * C$$

avec :

   $C$ une matrice incidence dudit réseau électrique obtenue à partir d'une topologie dudit réseau électrique de recharge sous la forme d'un réseau d'impédances,

   $Z_{bb}$ une matrice diagonale contenant une pluralité d'impédances, chaque impédance $z_{ii}$ correspondant à une borne de recharge $i$ de ladite pluralité de dipôles, ladite matrice impédance de boucle inversée modifiée $Z^{-1}_{loop\_M}$ étant déterminée par une relation de type « Sherman-Morrison » telle que :

$$Z^{-1}_{loop\_M} = Z^{-1}_{loop\_R} - \frac{(z'_{ii} - z_{ii})Z^{-1}_{loop\_R} l^t_i l_i Z^{-1}_{loop\_R}}{1 + (z'_{ii} - z_{ii})l_i Z^{-1}_{loop\_R} l^t_i}$$

   avec $l_i$ un vecteur ligne formé par la $i^{ème}$ ligne de ladite matrice incidence $C$,
   - vérification et/ou actualisation (13) de la valeur d'une puissance, dite puissance disponible $P_{disp\_i}$, apte à être délivrée par ladite borne de recharge $i$ en fonction de ladite tension modifiée $U'_i$, d'une puissance maximale fournie par ledit générateur de tension, et/ou d'une tension de seuil dudit réseau électrique, délivrant en cas d'actualisation une puissance disponible actualisée.

2. Procédé de détermination de tensions et/ou de puissances disponibles dans un réseau électrique de recharge selon la revendication 1, **caractérisé en ce que** ledit procédé de détermination comprend, audit premier instant $t_1$ les

étapes d'initialisation suivantes :

- détermination (1011) de la topologie dudit réseau électrique de recharge sous la forme d'un réseau d'impédances, chaque borne de recharge $i$ étant représentée par ladite impédance $z_{ji}$ prédéterminée,
- détermination (1012) de ladite matrice impédance de boucle de référence $Z_{loop\_R}$ représentative dudit réseau électrique de recharge,
- pour au moins ladite borne de recharge $i$, détermination d'une puissance disponible à tester $P_{test\_i}$, et détermination d'une tension d'initialisation $U_i$ par inversion (1013) de ladite matrice impédance de boucle de référence $Z_{loop\_R}$ délivrant ladite matrice impédance de boucle inversée de référence $Z_{loop\_R}^{-1}$,
- mémorisation (1014) de ladite matrice impédance de boucle inversée de référence $Z_{loop\_R}^{-1}$.

**3.** Procédé de détermination de tensions et/ou de puissances disponibles dans un réseau électrique de recharge selon la revendication 2, **caractérisé en ce que** ladite puissance disponible à tester $P_{test\_i}$ apte à être délivrée par ladite borne de recharge $i$ correspond à la première itération à la puissance maximale $P_{bMax}$ apte à être fournie par ladite borne de recharge $i$.

**4.** Procédé de détermination de tensions et/ou de puissances disponibles dans un réseau électrique de recharge selon l'une quelconque des revendications précédentes, **caractérisé en ce que**, ladite étape d'estimation délivre ladite impédance modifiée $z'_{ii}$ telle que $z'_{ii} = \dfrac{U_i^2}{P_{test\_i}}$.

**5.** Procédé de détermination de tensions et/ou de puissances disponibles dans un réseau électrique de recharge selon l'une quelconque des revendications 2 à 4, **caractérisé en ce que**, pour chaque itération, ladite étape d'actualisation d'une tension de ladite borne de recharge $i$ met en oeuvre au moins une itération des étapes successives suivantes :

- détermination (121) de ladite matrice inversée modifiée $Z_{loop\_M}^{-1}$ en fonction de ladite matrice inversée de référence $Z_{loop\_R}^{-1}$ et de ladite différence d'impédance entre ladite impédance modifiée $z'_{ii}$ et ladite impédance de référence $z_{ii}$,
- détermination (122) de ladite tension modifiée $U'_i$ à partir de ladite matrice inversée modifiée $Z_{loop\_M}^{-1}$,
- détermination (123) d'une estimation d'une puissance $P'_i$ délivrée par la borne de recharge $i$ telle que $P'_i = \dfrac{U'^2_i}{z'_{ii}}$,
- modifications (124) de l'impédance de référence $z_{ii}$ de sorte à être égale à ladite impédance modifiée $z'_{ii}$ délivrée par ladite étape d'estimation, et de la valeur de la matrice impédance de boucle inversée de référence $Z_{loop\_R}^{-1}$ de sorte à être égale à la valeur de la matrice impédance de boucle inversée modifiée $Z_{loop\_M}^{-1}$, et
- comparaison (125) à un premier seuil prédéterminé de la valeur absolue de la différence entre ladite estimation de la puissance $P'_i$ et ladite puissance disponible à tester $P_{test\_i}$ de ladite borne de recharge $i$, et fin desdites itérations desdites étapes successives de ladite étape d'actualisation d'une tension de ladite borne de recharge $i$ lorsque (126) ladite valeur absolue est inférieure à ladite valeur seuil, sinon, pour l'itération suivante (120) desdites étapes successives de ladite étape d'actualisation d'une tension de ladite borne de recharge $i$, modification (128) de ladite impédance modifiée $z'_{ii}$ telle que $z'_{ii} = \dfrac{U'^2_i}{P_{test\_i}}$.

**6.** Procédé de détermination de tensions et/ou de puissances disponibles dans un réseau électrique de recharge selon l'une quelconque des revendications 2 à 5, **caractérisé en ce que** lorsqu'une puissance totale correspondant à la somme des estimations de puissance délivrée par lesdits au moins deux dipôles est supérieure à ladite puissance maximale fournie par ledit générateur de tension ou lorsqu'une tension modifiée $U'_i$ d'au moins un desdits au moins deux dipôles est inférieure à ladite tension de seuil dudit réseau électrique, ladite étape de vérification et/ou d'actualisation de la valeur d'une puissance disponible de ladite borne de recharge $i$ met en oeuvre une étape d'actualisation de la valeur de ladite puissance disponible à tester $P_{test\_i}$ pour l'itération suivante,

et **en ce que** ladite étape d'actualisation de la valeur de ladite puissance disponible à tester $P_{test\_i}$ met en oeuvre une dichotomie telle que $P_{test\_i} = \frac{P_{max}+P_{min}}{2}$ avec $P_{max}$ correspondant, à l'initialisation, à la puissance maximale $P_{bMax}$ apte à être fournie par ladite borne de recharge $i$, puis à ladite estimation de la puissance $P'_i$ lorsque une puissance totale correspondant à la somme des estimations de puissance délivrée par lesdits au moins deux dipôles est supérieure à ladite puissance maximale fournie par ledit générateur de tension ou lorsqu'une tension modifiée $U'_i$ d'au moins une borne de recharge est inférieure à ladite tension de seuil dudit réseau électrique, et $P_{min}$ correspondant, à l'initialisation, à une puissance nulle, puis à ladite estimation de la puissance $P'_i$ lorsque ladite puissance totale est inférieure à ladite puissance maximale fournie par ledit générateur de tension et lorsque chaque tension de chacun desdits au moins deux dipôles est supérieure à ladite tension de seuil dudit réseau électrique, et lorsque $P_{max}$ est inférieure à la puissance maximale $P_{bMax}$ apte à être fournie par ladite borne de recharge $i$, et la différence entre la puissance $P_{max}$ et la puissance $P_{min}$ est supérieure à un deuxième seuil prédéterminé.

7. Procédé de détermination de tensions et/ou de puissances disponibles dans un réseau électrique de recharge selon l'une quelconque des revendications précédentes, **caractérisé en ce qu'**il comprend en outre une étape de signalisation représentative de ladite puissance disponible, apte à être délivrée par ladite borne de recharge $i$.

8. Dispositif de détermination de tensions et/ou de puissances disponibles dans un réseau électrique de recharge, ledit réseau électrique comprenant au moins un générateur de tension et au moins deux dipôles dont au moins une borne de recharge $i$ correspondant, à un premier instant $t_1$, à une impédance de référence $z_{ii}$ prédéterminée, **caractérisé en ce que** ledit dispositif de détermination comprend:

- un module d'estimation (443) d'un changement de ladite impédance de référence $z_{ii}$ en une impédance modifiée $z'_{ii}$,
- un module d'actualisation (444) d'une tension de ladite borne de recharge $i$, ladite actualisation mettant au moins en oeuvre une étape de détermination d'une matrice impédance de boucle inversée modifiée $Z^{-1}_{loop\_M}$ en fonction d'une matrice impédance de boucle inversée de référence $Z^{-1}_{loop\_R}$ et au moins en fonction d'une différence d'impédance entre ladite impédance modifiée $z'_{ii}$ et ladite impédance de référence $z_{ii}$, délivrant pour ladite borne de recharge $i$ une tension modifiée $U'_i$, ladite matrice impédance de boucle inversée de référence $Z^{-1}_{loop\_R}$ étant obtenue à partir d'une matrice impédance de boucle de référence $Z_{loop\_R}$ correspondant à un produit matriciel tel que :

$$Z_{loop\_R} = C^t * Z_{bb} * C$$

avec :

$C$ une matrice incidence dudit réseau électrique obtenue à partir d'une topologie dudit réseau électrique de recharge sous la forme d'un réseau d'impédances,

$Z_{bb}$ une matrice diagonale contenant une pluralité d'impédances, chaque impédance $z_{ii}$ correspondant à une borne de recharge $i$ de ladite pluralité de dipôles, ladite matrice impédance de boucle inversée modifiée $Z^{-1}_{loop\_M}$ étant déterminée par une relation de type « Sherman-Morrison » telle que :

$$Z^{-1}_{loop\_M} = Z^{-1}_{loop\_R} - \frac{(z'_{ii} - z_{ii})Z^{-1}_{loop\_R}l_i^t l_i Z^{-1}_{loop\_R}}{1 + (z'_{ii} - z_{ii})l_i Z^{-1}_{loop\_R}l_i^t}$$

avec $l_i$ un vecteur ligne formé par la $i^{ème}$ ligne de ladite matrice incidence $C$,
- un module de vérification et/ou d'actualisation (445) de la valeur d'une puissance, dite puissance disponible $P_{disp\_i}$, apte à être délivrée par ladite borne de recharge $i$ en fonction de ladite tension modifiée $U'_i$, d'une

puissance maximale fournie par ledit générateur de tension, et/ou d'une tension de seuil dudit réseau électrique, délivrant en cas d'actualisation une puissance disponible actualisée,

lesdits modules d'estimation, d'actualisation d'une tension, de vérification et/ou d'actualisation de la valeur d'une puissance, étant activés successivement, à au moins un deuxième instant $t_2$, pour au moins ladite borne de recharge $i$.

**9.** Programme d'ordinateur comportant des instructions pour la mise en oeuvre d'un procédé de transmission selon la revendication 1 lorsque ce programme est exécuté par un processeur.

**Patentansprüche**

**1.** Verfahren zur Bestimmung von in einem elektrischen Wiederaufladenetzwerk verfügbaren Spannungen und/oder Leistungen, wobei das elektrische Netzwerk mindestens einen Spannungsgenerator und mindestens zwei Dipole umfasst, darunter mindestens eine Ladestation $i$, die zu einem ersten Zeitpunkt $t_1$ einer vorbestimmten Referenz-impedanz $z_{ii}$ entspricht,
**dadurch gekennzeichnet, dass** das Verfahren zur Bestimmung, zu mindestens einem zweiten Zeitpunkt $t_2$, mindestens eine Iteration der folgenden aufeinanderfolgenden Schritte für mindestens die Ladestation $i$ durchführt:

- Schätzen (11) einer Änderung der Referenzimpedanz $z_{ii}$ in eine modifizierte Impedanz $z'_{ii}$,
- Aktualisieren (12) einer Spannung der Ladestation $i$, wobei die Aktualisierung mindestens einen Schritt zur Bestimmung einer modifizierten invertierten Schleifenimpedanzmatrix $Z_{loop\_M}^{-1}$ in Abhängigkeit von einer invertierten Referenz-Schleifenimpedanzmatrix $Z_{loop\_R}^{-1}$ und mindestens in Abhängigkeit von einer Impedanzdifferenz zwischen der modifizierten Impedanz $z'_{ii}$ und der Referenzimpedanz $z_{ii}$ durchführt, eine für die Ladestation $i$ modifizierte Spannung $U'_i$ liefert, wobei die invertierte Referenz-Schleifenimpedanzmatrix $Z_{loop\_R}^{-1}$ aus einer Referenz-Schleifenimpedanzmatrix $Z_{loop\_R}$ erhalten wird, die einem Matrixprodukt entspricht, sodass:

$$Z_{loop\_R} = C^t * Z_{bb} * C$$

mit:

$C$ als eine Inzidenzmatrix des elektrischen Netzwerks, die aus einer Topologie des Wiederaufladenetzwerks in Form eines Netzwerks von Impedanzen erhalten wird,
$Z_{bb}$ als eine Diagonalmatrix, die eine Vielzahl von Impedanzen enthält, wobei jede Impedanz $z_{ii}$ einer Ladestation $i$ aus der Vielzahl von Dipolen entspricht, wobei die modifizierte invertierte Schleifenimpedanzmatrix $Z_{loop\_M}^{-1}$ durch eine Beziehung vom Typ "Sherman-Morrison" bestimmt wird, sodass:

$$Z_{loop\_M}^{-1} = Z_{loop\_R}^{-1} - \frac{(z'_{ii} - z_{ii})Z_{loop\_R}^{-1} l_i^t l_i Z_{loop\_R}^{-1}}{1 + (z'_{ii} - z_{ii})l_i Z_{loop\_R}^{-1} l_i^t}$$

mit $l_i$ als ein Linienvektor, der durch die $i$-te Linie der Inzidenzmatrix C gebildet wird,
- Überprüfen und/oder Aktualisieren (13) des Wertes einer Leistung, genannt verfügbare Leistung $P_{disp\_i}$, die imstande ist, von der Ladestation $i$ in Abhängigkeit von der modifizierten Spannung $U'_i$ geliefert zu werden, einer vom Spannungsgenerator gelieferten maximalen Leistung und/oder einer Schwellenspannung des elektrischen Netzwerks, das im Falle einer Aktualisierung eine aktualisierte verfügbare Leistung liefert.

**2.** Verfahren zur Bestimmung von in einem elektrischen Wiederaufladenetzwerk verfügbaren Spannungen und/oder Leistungen nach Anspruch 1, **dadurch gekennzeichnet, dass** das Verfahren zur Bestimmung zu dem ersten Zeitpunkt $t1$ die folgenden Initialisierungsschritte umfasst:

- Bestimmen (1011) der Topologie des elektrischen Wiederaufladenetzwerks in der Form eines Netzwerks von Impedanzen, wobei jede Ladestation $i$ durch die vorbestimmte Impedanz $z_{ii}$ repräsentiert wird,

- Bestimmen (1012) der für das Wiederaufladenetzwerk repräsentativen Referenz-Schleifenimpedanzmatrix $Z_{loop-R}$,

- Bestimmen, für mindestens die Ladestation $i$, einer verfügbaren zu prüfenden Leistung $P_{test\_i}$, und Bestimmen einer Initialisierungsspannung $U_i$ durch Invertieren (1013) der Referenz-Schleifenimpedanzmatrix $Z_{loop-R}$, welche die invertierte Referenz-Schleifenimpedanzmatrix $Z_{loop\_R}^{-1}$ liefert,

- Speichern (1014) der invertierten Referenz-Schleifenimpedanzmatrix $Z_{loop\_R}^{-1}$.

3. Verfahren zur Bestimmung von in einem elektrischen Wiederaufladenetzwerk verfügbaren Spannungen und/oder Leistungen nach Anspruch 2, **dadurch gekennzeichnet, dass** die zu prüfende verfügbare Leistung $P_{test\_i}$, die imstande ist, von der Ladestation $i$ geliefert zu werden, der ersten Iteration bei maximaler Leistung $P_{bMax}$, die imstande ist, von der Ladestation $i$ geliefert zu werden, entspricht.

4. Verfahren zur Bestimmung von in einem elektrischen Wiederaufladenetzwerk verfügbaren Spannungen und/oder Leistungen nach einem der vorstehenden Ansprüche, **dadurch gekennzeichnet, dass** der Schritt des Schätzens die modifizierte Impedanz $z'_{ii}$ liefert, sodass ; $z'_{ii} = \dfrac{U_i^2}{P_{test\_i}}$.

5. Verfahren zur Bestimmung von in einem elektrischen Wiederaufladenetzwerk verfügbaren Spannungen und/oder Leistungen nach einem der Ansprüche 2 bis 4, **dadurch gekennzeichnet, dass** der Schritt des Aktualisierens einer Spannung der Ladestation $i$, für jede Iteration, mindestens eine Iteration der folgenden aufeinanderfolgenden Schritte durchführt:

- Bestimmen (121) der modifizierten invertierten Matrix $Z_{loop\_M}^{-1}$ in Abhängigkeit von der invertierten Referenzmatrix $Z_{loop\_R}^{-1}$ und der Impedanzdifferenz zwischen der modifizierten Impedanz $z'_{ii}$ und der Referenzimpedanz $z_{ii}$,

- Bestimmen (122) der modifizierten Spannung $U'_i$ aus der modifizierten invertierten Matrix $Z_{loop\_M}^{-1}$,

- Bestimmen (123) einer Schätzung einer von der Ladestation $i$ gelieferten Leistung $P'_i$, sodass $P'_i = \dfrac{U'_i{}^2}{z'_{ii}}$

- Modifizierungen (124) der Referenzimpedanz $z_{ii}$, sodass sie gleich der modifizierten Impedanz $z'_{ii}$ ist, die durch den Schritt des Schätzens geliefert wird, und des Werts der invertierten Referenz-Schleifenimpedanzmatrix $Z_{loop\_R}^{-1}$, sodass sie gleich dem Wert der modifizierten invertierten Schleifenimpedanzmatrix $Z_{loop\_M}^{-1}$ ist, und

- Vergleichen (125) mit einem ersten vorbestimmten Schwellenwert des Absolutwerts der Differenz zwischen der Schätzung der Leistung $P'_i$ und der zu prüfenden verfügbaren Leistung $P_{test\_i}$ der Ladestation $i$, und Ende der Iterationen der aufeinanderfolgenden Schritte des Schrittes des Aktualisierens einer Spannung der Ladestation $i$, wenn (126) der Absolutwert kleiner als der Schwellenwert ist, andernfalls, für die folgende Iteration (120) der aufeinanderfolgenden Schritte des Schrittes des Aktualisierens einer Spannung der Ladestation $i$, Modifizieren (128) der modifizierten Impedanz $z'_{ii}$, sodass $z'_{ii} = \dfrac{U'_i{}^2}{P_{test\_i}}$.

6. Verfahren zur Bestimmung von in einem elektrischen Wiederaufladenetzwerk verfügbaren Spannungen und/oder Leistungen nach einem der Ansprüche 2 bis 5, **dadurch gekennzeichnet, dass**, wenn eine Gesamtleistung, die der Summe der von den mindestens zwei Dipolen gelieferten Leistungsschätzungen entspricht, größer ist als die vom Spannungsgenerator gelieferte maximale Leistung, oder wenn eine modifizierte Spannung $U'_i$ von mindestens einem der mindestens zwei Dipole kleiner ist als die Schwellenspannung des elektrischen Netzwerks, der Schritt des Prüfens und/oder des Aktualisierens des Wertes einer verfügbaren Leistung der Ladestation $i$ einen Schritt des Aktualisierens des Wertes der zu prüfenden verfügbaren Leistung $P_{test\_i}$ für die nächste Iteration durchführt, und dadurch, dass der Schritt des Aktualisierens des Wertes der zu prüfenden verfügbaren Leistung $P_{test\_i}$ eine Dichotomie durchführt, sodass $P_{test\_i} = \frac{P_{max} + P_{min}}{2}$ mit $P_{max}$, das bei der Initialisierung, der maximalen Leistung $P_{bMax}$ entspricht, die imstande ist, von der Ladestation $i$ geliefert zu werden, dann der Schätzung der Leistung $P'_i$, wenn eine Gesamtleistung, die der Summe der von den mindestens zwei Dipolen gelieferten Leistungsschätzungen entspricht, größer ist als die vom Spannungsgenerator gelieferte maximale Leistung, oder wenn eine modifizierte Spannung $U'_i$ von mindestens einer Ladestation kleiner ist als die Schwellenspannung des elektrischen Netzwerks, und

$P_{min}$, bei der Initialisierung, einer Nullleistung entspricht, dann der Schätzung der Leistung $P'_i$, wenn die Gesamtleistung kleiner ist als die vom Spannungsgenerator gelieferte maximale Leistung, und wenn jede Spannung jedes der mindestens zwei Dipole größer ist als die Schwellenspannung des elektrischen Netzwerks, und wenn $P_{max}$ kleiner ist als die maximale Leistung $P_{bMax}$, die imstande ist, von der Ladestation $i$ geliefert zu werden, und die Differenz zwischen der Leistung $P_{max}$ und der Leistung $P_{min}$ größer als ein zweiter vorbestimmter Schwellenwert ist.

7. Verfahren zur Bestimmung von in einem elektrischen Wiederaufladenetzwerk verfügbaren Spannungen und/oder Leistungen nach einem der vorstehenden Ansprüche, **dadurch gekennzeichnet, dass** es weiter einen Signalisierungsschritt umfasst, der für die verfügbare Leistung repräsentativ ist, die imstande ist, von der Ladestation $i$ geliefert zu werden.

8. Vorrichtung zur Bestimmung von in einem elektrischen Wiederaufladenetzwerk verfügbaren Spannungen und/oder Leistungen, wobei das elektrische Netzwerk mindestens einen Spannungsgenerator und mindestens zwei Dipole umfasst, darunter mindestens eine Ladestation $i$, die, zu einem ersten Zeitpunkt $t_1$, einer vorbestimmten Referenzimpedanz $z_{ii}$ entspricht,
**dadurch gekennzeichnet, dass** die Vorrichtung zur Bestimmung umfasst:

- ein Modul zum Schätzen (443) einer Änderung der Referenzimpedanz $z_{ii}$ in eine modifizierte Impedanz $z'_{ii}$,
- ein Modul zum Aktualisieren (444) einer Spannung der Ladestation $i$, wobei die Aktualisierung mindestens einen Schritt zur Bestimmung einer modifizierten invertierten Schleifenimpedanzmatrix $Z_{loop\_M}^{-1}$ in Abhängigkeit auf einer invertierten Referenz-Schleifenimpedanzmatrix $Z_{loop\_R}^{-1}$ und mindestens in Abhängigkeit von einer Impedanzdifferenz zwischen der modifizierten Impedanz $z'_{ii}$ und der Referenzimpedanz $z_{ii}$, durchführt, eine für die Ladestation $i$ modifizierte Spannung $U'_i$ liefert, wobei die invertierte Referenz-Schleifenimpedanzmatrix $Z_{loop\_R}^{-1}$ aus einer Referenz-Schleifenimpedanzmatrix $Z_{loop\_R}$ erhalten wird, die einem Matrixprodukt entspricht, sodass:

$$Z_{loop\_R} = C^t * Z_{bb} * C$$

mit:

C als eine Inzidenzmatrix des elektrischen Netzwerks, die aus einer Topologie des Wiederaufladenetzwerks in der Form eines Netzwerks von Impedanzen erhalten wird,
$Z_{bb}$ als eine Diagonalmatrix, die eine Vielzahl von Impedanzen enthält, wobei jede Impedanz $Z_{ii}$ einer Ladestation $i$ aus der Vielzahl von Dipolen entspricht, wobei die modifizierte invertierte Schleifenimpedanzmatrix $Z_{loop\_M}^{-1}$ durch eine Beziehung vom Typ "Sherman-Morrison" bestimmt wird, sodass:

$$Z_{loop\_M}^{-1} = Z_{loop\_R}^{-1} - \frac{(z'_{ii} - z_{ii})Z_{loop\_R}^{-1} l_i^t l_i Z_{loop\_R}^{-1}}{1 + (z'_{ii} - z_{ii}) l_i Z_{loop\_R}^{-1} l_i^t}$$

mit $l_i$ als einem Linienvektor, der durch die $i$-te Linie der Inzidenzmatrix $C$ gebildet wird,

- ein Modul zum Überprüfen und/oder Aktualisieren (445) des Wertes einer Leistung, genannt verfügbare Leistung $P_{disp\_i}$, die imstande ist, von der Ladestation $i$ in Abhängigkeit von der modifizierten Spannung $U'_i$ geliefert zu werden, einer vom Spannungsgenerator gelieferten maximalen Leistung und/oder einer Schwellenspannung des elektrischen Netzwerks, das im Falle einer Aktualisierung eine aktualisierte verfügbare Leistung liefert,

wobei die Module zum Schätzen, Aktualisieren einer Spannung, Überprüfen und/oder Aktualisieren des Wertes einer Leistung, zu mindestens einem zweiten Zeitpunkt $t_2$, für mindestens die Ladestation $i$ nacheinander aktiviert werden.

9. Computerprogramm, Anweisungen zur Durchführung eines Übertragungsverfahrens nach Anspruch 1 beinhaltend, wenn dieses Programm von einem Prozessor ausgeführt wird.


**Claims**

1. Method for determining voltages and/or power available in an electrical recharging network, said electrical network comprising at least one voltage generator and at least two dipoles, of which at least one recharging terminal $i$ corresponding, at a first instant $t_1$, to a predetermined reference impedance $z_{ii}$,
**characterised in that** the determination method implements, at at least one second instant $t_2$, at least one iteration of the following successive steps, for said at least one recharging terminal $i$:

- estimation (11) of a change of said reference impedance $z_{ii}$ to a modified impedance $z'_{ii}$,
- updating (12) of a voltage of said recharging terminal $i$, said updating at least implementing a step for the determination of a modified inverted loop impedance matrix $Z^{-1}_{loop\_M}$ as a function of a reference inverted loop impedance matrix $Z^{-1}_{loop\_R}$ and at least as a function of an impedance difference between said modified impedance $z'_{ii}$ and said reference impedance $z_{ii}$, delivering for said recharging terminal $i$ a modified voltage $U'_i$, said reference inverted loop impedance matrix $Z^{-1}_{loop\_R}$ being obtained from a reference loop impedance matrix $Z_{loop-R}$ corresponding to a matrix multiplication such that:

$$Z_{loop\_R} = C^t * Z_{bb} * C$$

with:

$C$ an incidence matrix of said electrical network obtained from a topology of said electrical recharging network in the form of an impedance network:
$Z_{bb}$ a diagonal matrix containing a plurality of impedance values, each impedance $z_{ii}$ corresponding to a recharging terminal $i$ of said plurality of dipoles, said modified inverted loop impedance matrix $Z^{-1}_{loop\_M}$ being determined by a "Sherman-Morrison"-type relationship such that:

$$Z^{-1}_{loop\_M} = Z^{-1}_{loop\_R} - \frac{(z'_{ii} - z_{ii})Z^{-1}_{loop\_R} l^t_i l_i Z^{-1}_{loop\_R}}{1 + (z'_{ii} - z_{ii}) l_i Z^{-1}_{loop\_R} l^t_i}$$

with $l_i$ a row vector formed by the $i^{th}$ row of said incidence matrix $C$,

- verification and/or update (13) of a power value, said available power $P_{disp\_i}$, ready to be delivered by said recharging terminal $i$ based on said modified voltage $U'_i$, of a maximum power supplied by said voltage generator, and/or a threshold voltage of said electrical network, delivering in case of an update, an updated available power.

2. Method for determining voltages and/or power available in an electrical recharging network according to claim 1, **characterised in that** said determination method comprises, at said first instant $t_1$, the following initialisation steps:

- determination (1011) of the topology of said electrical recharging network in the form of an impedance network, each recharging terminal $i$ being represented by said predetermined impedance $z_{ii}$,
- determination (1012) of said reference loop impedance matrix $Z_{loop-R}$ representative of said electrical recharging network,
- for at least said recharging terminal $i$, determination of a power available to be tested $P_{test\_i}$, and determination of an initialisation voltage $U_i$ by inversion (1013) of said reference loop impedance matrix $Z_{loop-R}$ delivering said reference inverted loop impedance matrix $Z_{loop\_R}^{-1}$,

- memorising (1014) said reference inverted loop impedance matrix $Z_{loop\_R}^{-1}$.

**3.** Method for determining voltages and/or power available in an electrical recharging network according to claim 2, **characterised in that** said available power to be tested $P_{test\_i}$ capable of being delivered by said recharging terminal $i$ corresponds in the first iteration to the maximum power $P_{bMax}$ capable of being supplied by said charging terminal $i$.

**4.** Method for determining voltages and/or power available in an electrical recharging network according to any one of the preceding claims, **characterised in that** said estimation step delivers said modified impedance $z'_{ii}$ such that

$$z'_{ii} = \frac{U_i^2}{P_{test\_i}}.$$

**5.** Method for determining voltages and/or power available in an electrical recharging network according to one of claims 2 to 4, **characterised in that**, for each iteration, said step of updating a voltage of said recharging terminal $i$ implements at least one iteration of the following successive steps:

- determination (121) of said modified inverted matrix $Z_{loop\_M}^{-1}$ as a function of said reference inverted matrix and said impedance difference between said modified impedance $z'_{ii}$ and said reference impedance $z_{ii}$,

- determination (122) of said modified voltage $U'_i$ from said modified inverted matrix $Z_{loop\_M}^{-1}$,

- determination (123) of an estimation of a power $P'_i$ delivered by the charging terminal $i$ such that $P'_i = \frac{U'^2_i}{z'_{ii}}$,

- modifications (124) of the reference impedance $z_{ii}$ so that it is equal to said modified impedance $z'_{ii}$ delivered by said estimation step, and of the value of the reference inverted loop impedance matrix $Z_{loop\_R}^{-1}$ so that it is equal to the value of the modified inverted loop impedance matrix $Z_{loop\_M}^{-1}$, and

- comparison (125) to a first predetermined threshold of the absolute value of the difference between said estimation of the power $P'_i$ and said available power to be tested $P_{test\_i}$ of said recharging terminal $i$, and end of said iterations of said successive steps of said updating step of a voltage of said recharging terminal $i$ when (126) said absolute value is lower than said threshold value, or otherwise, for the subsequent iteration (120) of said successive steps of said updating step of a voltage of said recharging terminal $i$, modification (128) of said modified impedance $z'_{ii}$ such that $z'_{ii} = \frac{U'^2_i}{P_{test\_i}}$.

**6.** Method for determining voltages and/or power available in an electrical recharging network according to one of claims 2 to 5, **characterised in that** when a total power corresponding to the sum of the estimations of power delivered by said at least two dipoles is greater than said maximum power supplied by the voltage generator or when a modified voltage $U'_i$ of at least one of said at least two dipoles is lower than said threshold voltage of said electrical network, said verification and/or update step of the value of an available power of said recharging terminal $i$ implements a step of updating the value of said available power to be tested $P_{test\_i}$ for the subsequent iteration, and **in that** said step of updating the value of said available power to be tested $Pt_{est\_i}$ implements a dichotomy such that $P_{test\_i} = \frac{P_{max} + P_{min}}{2}$ with $P_{max}$ corresponding, upon initialisation, to the maximum power $P_{bMax}$ capable of being supplied by said recharging terminal $i$, then to said estimation of the power $P'_i$ when a total power corresponding to the sum of the estimations of power delivered by said at least two dipoles is greater than said maximum power supplied by said voltage generator, or when a modified voltage $U'_i$ of at least one recharging terminal is inferior to said threshold voltage of said electrical network, and

$P_{min}$ corresponding, upon initialisation, to a zero power, then to said estimation of the power $P'_i$ when said total power is inferior to said maximum power supplied by said voltage generator and when each voltage of each of said at least two dipoles is greater than said threshold voltage of said electrical network, and when $P_{max}$ is inferior to the maximum power $P_{bMax}$ ready to be supplied by said recharging terminal $i$ and the difference between the power $P_{max}$ and the power $P_{min}$ is greater than a second predetermined threshold.

7. Method for determining voltages and /or power available in an electrical recharging network according to any one of the preceding claims, **characterised in that** it further comprises a step of signalling representative of said available power ready to be delivered by said recharging terminal $i$.

8. Device for determining voltages and/or power available in an electrical recharging network, said electrical network comprising at least one voltage generator and at least two dipoles, of which at least one recharging terminal $i$ corresponding, at a first instant $t_1$, to a predetermined reference impedance $z_{ii}$,
**characterised in that** said determination device comprises:

- an estimation module (443) of a change of said reference impedance $z_{ii}$ to a modified impedance $z'_{ii}$,
- an update module (444) of a voltage of said recharging terminal $i$, said update at least implementing a step for the determination of a modified inverted loop impedance matrix $Z^{-1}_{loop\_M}$ based on a reference inverted loop impedance matrix $Z^{-1}_{loop\_R}$ and at least based on an impedance difference between said modified impedance $z'_{ii}$ and said reference impedance $z_{ii}$, delivering for said recharging terminal $i$ a modified voltage $U'_i$, said reference inverted loop impedance matrix $Z^{-1}_{loop\_R}$ being obtained from a reference loop impedance matrix $Z_{loop-R}$ corresponding to a matrix multiplication such that:

$$Z_{loop\_R} = C^t * Z_{bb} * C$$

with:

C an incidence matrix of said electrical network obtained from a topology of said electrical recharging network in the form of an impedance network:
$Z_{bb}$ a diagonal matrix containing a plurality of impedance values, each impedance $z_{ii}$ corresponding to a recharging terminal $i$ of said plurality of dipoles, said modified inverted loop impedance matrix $Z^{-1}_{loop\_M}$ being determined by a "Sherman-Morrison"-type relationship such that:

$$Z^{-1}_{loop\_M} = Z^{-1}_{loop\_R} - \frac{(z'_{ii} - z_{ii})Z^{-1}_{loop\_R}l_i^t l_i Z^{-1}_{loop\_R}}{1 + (z'_{ii} - z_{ii})l_i Z^{-1}_{loop\_R}l_i^t}$$

with $l_i$ a row vector formed by the $i^{th}$ row of said incidence matrix $C$,

- a verification and/or update module (445) of the power value, said available power $P_{disp\_i}$, capable of being delivered by said recharging terminal $i$ based on said modified voltage $U'_i$, of a maximum power supplied by said voltage generator, and/or a threshold voltage of said electrical network, delivering in case of an update an updated available power,

said modules for the estimation, voltage updating, verification and/or updating of a power value being successively activated, at least one second instant $t_2$, for at least said recharging terminal $i$.

9. Computer program comprising the instructions for the implementation of a transmission method according to claim 1 when said program is executed by a processor.

$Z^{-1}_{loop\text{-}R}$

Ens_Z$_{ii}$ — 1020

Ens_Z$_{ii}$ — 1010

Initialisation

Réception

Détermination + Mémorisation $U_i + P_{disp\_i}$ — 1021

$t_1$

Détermination topo — 1011 — 1000

Détermination $Z_{loop\_R}$ — 1012

Inversion $Z^{-1}_{loop\_R}$ — 1013

$U_i$

Mémorisation — 1014

$Z^{-1}_{loop\_R} + Ens - Z_{ii} + U_i + P_{disp\_i} + P_{test\_i}$

Estimation $Z'_{ii}$ — 10 — 11

$Z'_{ii}$

Actualisation $U_i$ en $U'_i$ — 12

Détermination de $Z^{-1}_{loop\_M}$ — 121

Détermination $U'_i$ — 122

Détermination $P'_i$ — 123

Modifications $Z_{ii}, Z^{-1}_{loop\_R}$

Itérarion — 120 — 124 — 125

100

$t_2$

$|P'_i - P_{test\_i}| < \xi_1$ ? — KO

Modification $Z'_{ii}$ — 126 — 128 — 127

Itérarion

$Z_{ii}, Z^{-1}_{loop\_R}, P'_i, U'_{i\,1 \leq i \leq m}$

Vérification et/ou Actualisation $P_{disp\_i}$ — 13

OK

132

KO — $P_{test\_i}$ OK?

Ens_$Z_{ii}, Z^{-1}_{loop\_R}, P_{test\_i}$

OK

$P_{disp\_i}$ — 133 — 131

t

## Fig. 1A

Fig. 1B

VE connecté

3,3k W

1    3    2    4

Borne non disponible

Fig. 2

$V_1$    $V_2$

1    $i_{12}$    $Z_4$    2    $i_{23}$    $Z_5$    3    $V_3$

$i_{24}$    $i_{34}$

$Z_1$

Boucle 1

$Z_2$    $Z_3$

U    G

4    Boucle 2

$i_{41}$    $V_4$

Fig. 3

441    443    444    445

R    Estim    Act-U'$_i$    Vérif/Act $P_{disp-i}$

DET $Z^{-1}_{loop\_R}$    μP    42

442    M    Pg

41    43

Fig. 4

**EP 3 152 812 B1**

**Littérature non-brevet citée dans la description**

- Graph Theory and Topology For 3 phase Power system under Faulted studies. *Tedja Santanoe Oepomo, IJRRAS,* Février 2012, vol. 10 (2